# EUROPEAN PATENT APPLICATION

(11) **EP 4 575 389 A1**
(43) Date of publication of application: **25.06.2025**
(21) Application number: 23220066.7
(22) Date of filing: 22.12.2023
(51) Int. Cl.: G01B 11/30, G01N 21/95, H01L 21/66

(54) **SENSOR AND METHOD FOR QUALIFICATION OF A TOPOGRAPHY OF A SURFACE OF A DIE FOR DIE BONDING**

(71) Applicant: ASML Netherlands B.V., 5500 AH Veldhoven (NL)
(72) Inventor: DE JAGER, Pieter, Willem, Herman, 5500 AH Veldhoven (NL); SCHOUTEN, Christine, Henriette, 5500 AH Veldhoven (NL); DOLK, Victor, Sebastiaan, 5500 AH Veldhoven (NL); WAHBEH, Lotfi, 5500 AH Veldhoven (NL); ASSENDELFT, Joep, 5500 AH Veldhoven (NL); BUSTRAAN, Krijn, Frederik, 5500 AH Veldhoven (NL); SAHIN, Buket, 5500 AH Veldhoven (NL); ALLELEIJN, Joep, Hanni, Hub, Maria, 5500 AH Veldhoven (NL); BROERS, Sander, Christiaan, 5500 AH Veldhoven (NL); VENUGOPALAN, Syam, Parayil, 5500 AH Veldhoven (NL)
(74) Representative: ASML Netherlands B.V.

(57) **Abstract**

A sensor and method of operating the sensor, the sensor configured to determine a characteristic of a topography of a surface of one or more semiconductor dies for die bonding, the sensor including a radiation emission system configured to emit radiation having a substantially flat wavefront; and a radiation detector configured to detect at least some of the radiation after reflection by the one or more semiconductor dies to determine the characteristic of the topography of the surface of the one or more semiconductor dies.

## Description

### TECHNICAL FIELD

The present disclosure relates generally to a sensor and method for qualification of a characteristic of a topography of a surface of a die for die bonding.

### BACKGROUND

In manufacturing processes of integrated circuits (ICs), multiple finished or unfinished ICs (e.g., whole wafers, diced wafers, partially diced wafers, chips, die, etc.) may be placed in contact, stacked, bonded, or otherwise joined (e.g., to heterogeneous or homogeneous devices) at various points in the fabrication process. Heterogeneous integration, e.g., the integration of different circuits or other patterned devices, may rely upon joining of specific portions (for example, conductive contact elements) of multiple die-where these specific portions may be aligned in three-dimensional space to ensure functional connectivity. Alignment of these die, which may have multiple fabrication layers, different critical dimensions, different nodes, packaging, etc., with each other may require different techniques than used for lithography during fabrication. As the physical sizes of IC components continue to shrink, and their structures continue to become more complex, accuracy and throughput in integration become more important. For applications such as heterogeneous integration, it may be desirable to obtain both accurate and fast placement of a die with respect to one another. In the context of semiconductor manufacture, improvements in die placement and alignment (e.g., improvements in heterogeneous integration) lead to improvements in IC manufacturing and integration abilities.

### SUMMARY

According to an embodiment, there is provided a sensor, the second configured to determine a characteristic of a topography of a surface of one or more semiconductor dies, the sensor comprising:
a radiation emission system configured to emit radiation having a substantially flat wavefront; and
a radiation detector configured to detect at least some of the radiation after reflection by the one or more semiconductor dies to determine the characteristic of one or more semiconductor dies.

According to an embodiment, there is provided a sensor, the sensor configured to determine a presence and/or absence of contamination on one or more semiconductor dies, the sensor comprising:
a radiation emission system configured to emit radiation having a substantially flat wavefront; and
a radiation detector configured to detect at least some of the radiation after reflection by the one or more semiconductor dies to determine the presence and/or absence of contamination on one or more semiconductor dies.

According to an embodiment, there is provided a system comprising the sensor of any other embodiment and a movable substrate configured to provide relative movement between the emitted radiation and the one or more semiconductor dies.

According to an embodiment, there is provided a system for die bonding comprising a sensor configured to determine a flatness of and/or presence of particles on, a surface of a die prior to bonding.

According to an embodiment, there is provided a particle detector, wherein the particle detector comprises the sensor of any other embodiment.

According to an embodiment, there is provided a method, the method comprising:
illuminating one or more semiconductor dies with radiation comprising a substantially flat wavefront;
detecting, by a radiation detector, at least some of the radiation reflected from the one or more semiconductor dies; and
determining, based on the detected reflected radiation, a characteristic of the topography of a surface of the one or more semiconductor dies.

According to an embodiment, there is provided one or more non-transitory, machine-readable medium having instructions therein, the instructions, when executed by a processor system, configured to cause the processor system to operate at least the sensor, system, or particle detector of any other embodiment.

According to another embodiment, one or more non-transitory, machine-readable medium is provided having instructions thereon, the instructions when executed by a processor being configured to perform a method as described herein.

### BRIEF DESCRIPTION OF THE DRAWINGS

The accompanying drawings, which are incorporated in and constitute a part of the specification, illustrate one or more embodiments and, together with the description, explain these embodiments. Embodiments of the invention will now be described, by way of example only, with reference to the accompanying schematic drawings in which corresponding reference symbols indicate corresponding parts, and in which:
Figures 1A-1D are schematic diagrams illustrating an exemplary die bonding method, according to one or more embodiments.
Figures 2A-2F are schematic diagrams illustrating an example method of die placement, according to one or more embodiments.
Figures 3A-3J are schematic diagrams illustrating portions of an example apparatus for die bonding, according to one or more embodiments.
Figures 4A-4D are schematic diagrams illustrating example effects of surface topography on die bonding, in accordance with one or more embodiments.
Figures 5A-5C are schematic diagrams illustrating example methods and systems for qualification a characteristic of a topography of a surface of a die for, or during, die bonding, according to one or more embodiments.
Figure 6 is a flowchart which illustrates an exemplary method of die placement, according to one or more embodiments.
Figure 7 is a flowchart which illustrates an exemplary method of qualification of a characteristic of a topography of a surface of a die, according to one or more embodiments.
Figure 8 is a block diagram of an example computer system, according to one or more embodiments of the present disclosure.

### DETAILED DESCRIPTION

Embodiments of the present disclosure are described in detail with reference to the drawings, which are provided as illustrative examples of the disclosure so as to enable those skilled in the art to practice the disclosure. Notably, the figures and examples below are not meant to limit the scope of the present disclosure to a single embodiment, but other embodiments are possible by way of interchange of some or all of the described or illustrated elements. Moreover, where certain elements of the present disclosure can be partially or fully implemented using known components, only those portions of such known components that are necessary for an understanding of the present disclosure will be described, and detailed descriptions of other portions of such known components will be omitted so as not to obscure the disclosure. Embodiments described as being implemented in software should not be limited thereto, but can include embodiments implemented in hardware, or combinations of software and hardware, and vice-versa, as will be apparent to those skilled in the art, unless otherwise specified herein. In the present specification, an embodiment showing a singular component should not be considered limiting; rather, the disclosure is intended to encompass other embodiments including a plurality of the same component, and vice-versa, unless explicitly stated otherwise herein. Moreover, applicants do not intend for any term in the specification or claims to be ascribed an uncommon or special meaning unless explicitly set forth as such. Further, the present disclosure encompasses present and future known equivalents to the known components referred to herein by way of illustration.

Although specific reference may be made in this text to the manufacture of ICs, it should be explicitly understood that the description herein has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "wafer" or "die" in this text should be considered as interchangeable with the more general terms "substrate" and "target portion", respectively. The term "wafer" may be used generally to refer to a large unit of manufacture (which may be the largest unit of manufacture), while the term "die" may be used to refer to a smaller unit of manufacture which may correspond to a lithography pattern, a portion of a lithography pattern, multiple lithography patterns, etc. A "die" may correspond to a portion of "wafer"-that is a "die" may be produced by dicing or otherwise dividing a "wafer". The term "die" should be considered as interchangeable with the term chip, chiplet, or other terms for IC divisions. A patterning device (for example, a lithography device) can comprise, or can form, one or more patterns, which may correspond to one or more die. The patterns can be generated utilizing CAD (computer-aided design) programs, based on a pattern or design layout, this process often being referred to as EDA (electronic design automation). As used throughout this application "or", unless indicated otherwise, takes a non-exclusive meaning, e.g., encompassing both "and" and "or". "Each", "every", "all", "corresponding", "individual" and other relational terms encompass substantially "each", "every", "all", etc., including cases in which each, every, all, corresponding, individual, etc. may include relationship which are not one-to-one, or do not include every possible item. For example, every may exclude items, such as items determined to be defective during testing. Each may exclude items, such as edge items, which are not used. All may exclude items, such as excess items. Corresponding may not require that items correspond in an exactly one to one manner. For example, a first item may correspond to two of a second item or vice versa. In some cases, individual may refer to multiple of an item, such as each item A has individual item B, where an item A may have two of an item B.

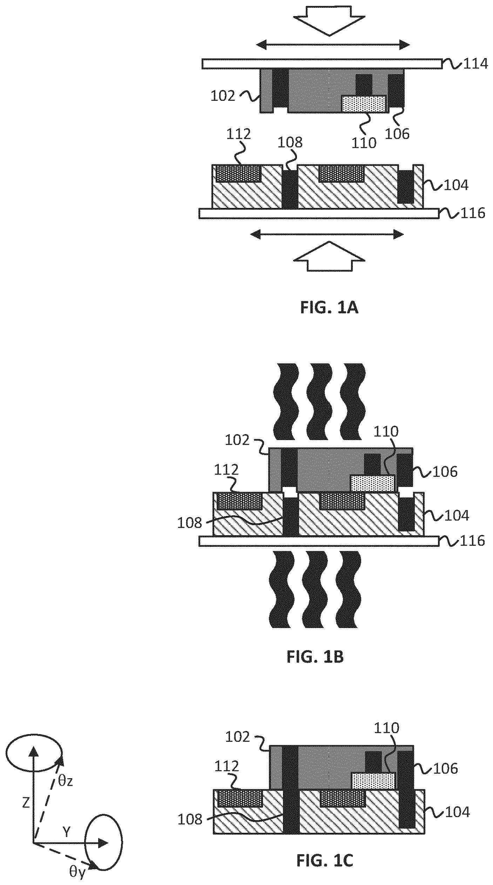

Reference is now made to Figures 1A-1D, which are schematic diagrams illustrating an exemplary die bonding method consistent with embodiments of the present disclosure. The exemplary die bonding method is depicted in relation to a reference set of axes, which are consistent through the schematic illustrations. The reference axes are provided for ease of description only and are not to be taken as limiting. Included methods and apparatuses may instead be described with reference to a different set of axes (e.g., cylindrical coordinates, polar coordinates, etc.), a different origin point (e.g., an origin point in the donor die, an origin point in the target, origin point in between the donor die and target, etc.), or a different orientation. The reference set of axes is chosen such that the fabrication plane of the die (i.e., a substrate surface) lies in the x-y plane and where the fabrication direction is parallel or antiparallel to the z-axis for both the donor die and target locations.

As shown in Figures 1A-1D, the exemplary die bonding method may involve a donor die 102 and a target die 104. Herein, the term "donor" and the term "target" are used for ease of description. It should be understood that the term "donor" and the term "target" are provided for reference and are relative descriptions, and that elements described as corresponding to a "donor" can instead correspond to a "target" and vice versa. A target die may also or instead be called an acceptor die. Further, while just one donor die and target die are depicted in Figure 1A, it will be appreciated that there may be multiple such die and that multiple donor die may be essentially simultaneously bonded with multiple target die, e.g., where, for example, multiple die are still part of (all or part) a substrate in or on which they are formed.

The donor die 102 may have one or more electrically active areas 106, such as on an alignment face of the donor die 102. The one or more electrically active areas 106 may be conductive, such as metal. The one or more electrically active areas 106 may correspond to one or more vias (e.g., one or more through silicon vias (TSVs)), one or more electrical contact lines, one or more contact pads, one or more packaging pads, or other one or more electrically conductive areas. The donor die 102 may have one or more electrically inert areas (for example, an electrically insulating area) outside of the one or more electrically active areas 106, such as on the alignment face of the donor die 102. The one or more electrically active areas 106 may be recessed (as shown) with respect to one or more other surfaces of the donor die 102. The one or more electrically active areas 106 may correspond to one or more contacts (e.g., to source, to drain, to gate, etc.) to one or more electrical devices within the donor die 102 (not shown). The target die 104, likewise, may have one or more electrically active areas 108, which may have one or more similar properties to the one or more electrically active areas 106.

The donor die 102 may also or instead have one or more doped areas 110, such as on an alignment face of the donor die 102, recessed below the alignment face of the donor die 102, etc. While the term "doped" is used, it should be understood that the one or more doped areas 110 may be any areas which, through the course of fabrication, come to have one or more different electrical characteristics than the bulk of the substrate (e.g., silicon wafer). The one or more doped areas 110 may correspond to source, drain, gate, ground, or other areas of a circuit which is doped or otherwise altered (e.g., through implantation, oxide growth, thin film deposition, etc.) to have a different electrical characteristic than the bulk of the substrate. The one or more doped areas 110 may include one or more conductive layers (e.g., one or more highly doped or electrically conductive layers) and/or one or more insulative layers (e.g., one or more oxide layers). The donor die 102 may have one or more undoped areas (for example, an area where the substrate retains the characteristic of the bulk substrate) outside of the one or more doped areas 110, such as on the alignment face of the donor die 102. The one or more doped areas 110 may be recessed, buried, coplanar (as shown), etc. with respect to one or more other surfaces of the donor die 102. The one or more doped areas 110 may correspond to one or more regions (e.g., to one or more source regions, one or more drain regions, one or more gate regions, one or more dielectric regions, etc.) of one or more electrical devices within the donor die 102 or one or more regions which may form one or more electrical devices across both the donor die 102 and the acceptor die 104 once those die are bonded. The target die 104, likewise, may have one or more doped areas 112, which may have one or more similar properties to the one or more doped areas 110.

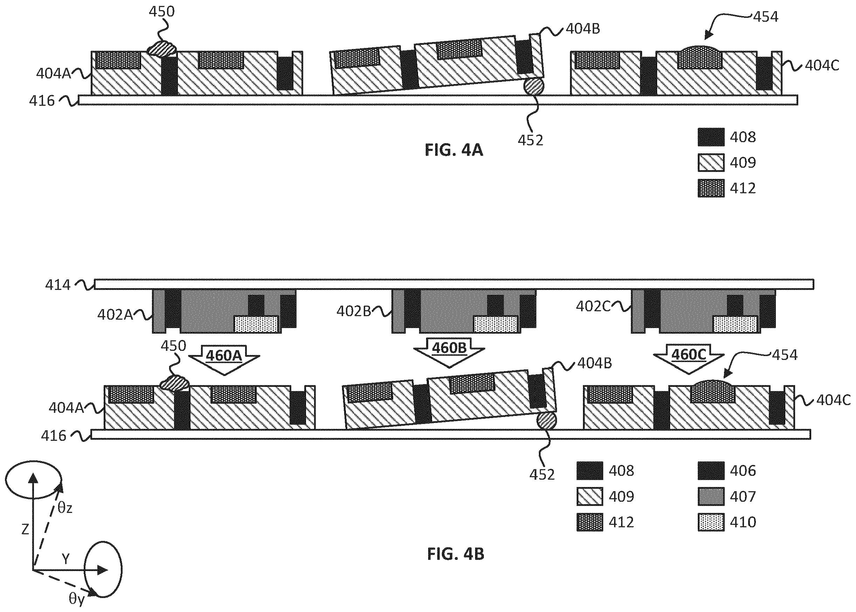

As shown in Figures 1A and 1B, the exemplary die bonding method may involve alignment of at least one of the electrically active areas 106 and/or doped areas 110 of the donor die 102 with at least one of the electrically active areas 108 and/or doped areas 112 of the target die 104. The exemplary die bonding method may involve bringing the donor die 102 into contact with the target die 104 while maintaining alignment between, e.g., one or more electrically active areas 106 and one or more electrically active areas 108 so that the one or more electrically active areas 106 and the one or more electrically active areas 108 may be joined for cross-die electrical communication. The exemplary die bonding method may be affected by a topography of a surface (e.g., flatness) of the donor die 102 and/or target die 104, as will be described in more detail in reference to Figures 4A-4D. The exemplary die bonding method may involve aligning one or more doped areas 110 of the donor die 102 with one or more doped areas 112 of the target die 104. Aligning may encompass bringing into contact, aligning one or more edges of various regions, having overlap, having non-overlap, or any other appropriate alignment scheme. The exemplary die bonding method may involve applying or maintaining pressure between the donor die 102 and the target die 104, while bonding occurs between the donor die 102 and the target die 104. The donor die 102 may be supported by a carrier structure 114, which may be a substrate which is transparent to a range of radiation (e.g., infrared radiation, a portion of the optical spectrum, etc.). The target die 104 may likewise be supported by a carrier structure 116, which may or may not be transparent to a range of radiation. The target die 104 may be a wafer (e.g., containing one or more fabricated semiconductor chip). The target die 104 may be a die which is part of an un-diced wafer, where the un-diced wafer may contain multiple die. In some embodiments, the target die 104 may be separated from other die (e.g., by dicing) after die bonding. The alignment may be complicated by the multiple layers of the donor die 102 or the multiple layers of the target die 104, which may be optically opaque.

Figures 1A and 1B depict a cross-sectional view of portions of the exemplary die bonding method showing relative positioning between the donor die 102 and the target die 104. As shown in Figure 1A, the donor die 102 and the target die 104 may be brought together along the z-axis, while the position of the donor die 102 or the target die 104 may be adjusted in the x-y plane (e.g., perpendicular to the z-axis of approach), such as to improve alignment between the donor die 102 and the target die 104. As shown in Figure 1B, alignment can be achieved between, e.g., one or more electrically active areas 106 and one or more electrically active areas 108 and/or between one or more doped areas 110 of the donor die 102 with one or more doped areas 112 of the target die 104.

Once aligned, the donor die 102 and the target die 104 are bonded together. In an embodiment, the bonding is a direct or fusion bonding (e.g., involving van der Waals forces). In an embodiment, the bonding is an intermolecular bonding, e.g., van der Waals bonding. In an embodiment, the bonding may include covalent, ionic, or metallic (e.g., chemical) bonding. In an embodiment, the bonding is aided by a material (e.g., a suitable bonding or adhesive material) applied to an alignment surface of the donor die 102 and/or target die 104 or provided to a gap between the donor die 102 and the target die 104 (e.g., in the form of gas or liquid). In some embodiments, physical contact between the donor die 102 and the target die 104 may include bonding, such as through a bonding wavefront generated by contact (or atomic level proximity), such as of a surface prepared for hydrogen bonding.

As shown in Figure 1B, the donor die 102 and the target die 104 may be annealed after contact as depicted by the wavy lines (while wavy lines are shown here at both the donor die 102 and the target die 104, the annealing agent need not be provided at both the donor die 102 and the target die 102 nor needs to be applied in the direction(s) shown). Annealing may be or include heat annealing, electrical annealing, electrostatic processes, etc. In some embodiments, annealing may include annealing of in-plane (or prominent) regions that are bonded and/or annealing of one or more recessed areas which may increase the volume of fill in a recess area (such as through thermal expansion, capillary force, etc.) and may cause physical contact and bonding of areas previously not in contact. As shown in Figure 1C, annealing may cause physical or chemical changes, such as in the one or more electrically active areas 106 of the donor die 102 or in the one or more electrically active areas 108 of the target die 104, which may cause or improve physical contact or electrical contact between an electrically active area 106 and an electrically active area 108. Annealing may therefore produce or enhance electrical connectivity between elements of the donor die 102 and the target die 104 (e.g., integration). This electrical connectivity may occur even if an electrically active area 106 and an electrically active area 108 differ-for example, have different recessed depths, are made up of different materials, have different dimensions, etc. In an embodiment, the prior bonding described with respect to Figure 1A may be temporary during one or more portions of the annealing process, wherein the annealing process forms tight connections between donor die 102 and the target die 104. In an embodiment, the annealing may occur in the system where the bonding occurs. In an embodiment, the annealing may occur in a separate system from the system in which the bonding occurs, e.g., the donor and target dies are transported out of the bonding system into an annealing system which can include one or more heating elements (e.g., one or more electrical heating elements, one or more elements to provide radiation heating, etc.) to provide the heat for the annealing.

Once the donor die 102 and the target die 104 are bonded, the carrier structure 114 may be removed as shown in Figure 1B. Additionally or alternatively, the carrier structure 116 may be removed then as well. Alternatively, once the donor die 102 and the target die 104 are annealed, the carrier structure 116 may be removed as shown in Figure 1C. Additionally or alternatively, the carrier structure 114 may be removed then as well.

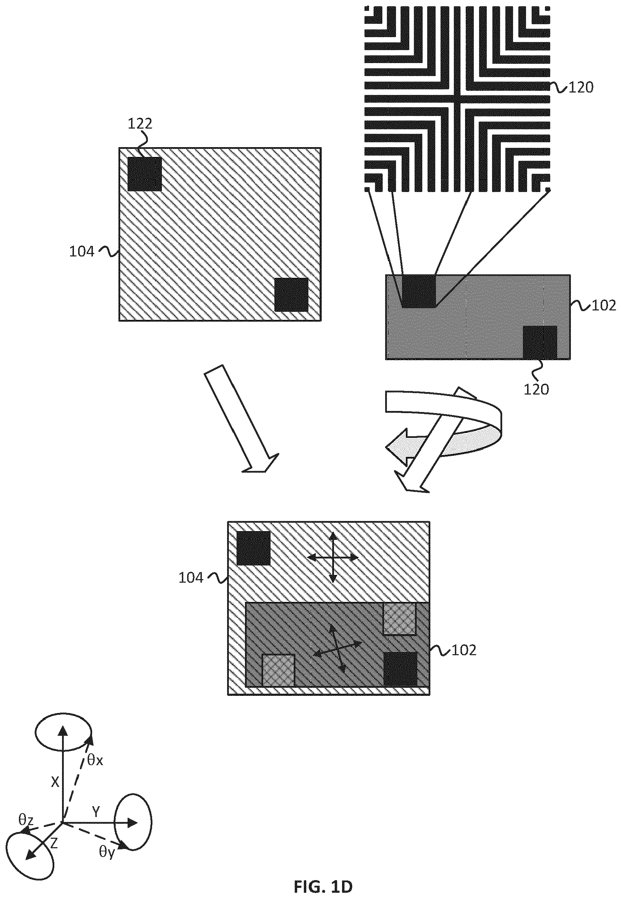

Figure 1D depicts a plan view of an example die bonding method according to this disclosure. As shown in Figure 1D, the donor die 102 and the target die 104 may have one or more alignment marks along the x-y plane to facilitate alignment of the die as a whole. Alignment marks in the x-y plane of a die (e.g., one or more alignment marks 120 on the donor die 102 or one or more alignment marks 122 on the target die 104) may reduce the area available for circuitry. One or more alignment marks may be placed in a waste area, such as an area between chips, which may then be destroyed (e.g., removed) during dicing. Dicing herein refers to mechanical separation of areas of a substrate (e.g., a unit of manufacture) into smaller areas (e.g., dies or chips) which may contain one or more units of operation (e.g., a logic device, a memory unit, etc.). Dicing may operate using any appropriate method-for example, scribing and breaking, mechanical sawing, laser cutting, etc.-and may destroy (e.g., grind to powder or otherwise render inoperable for circuitry placement) a non-zero linewidth portion of the substrate volume when separating die. Alignment marks may be additively or substractively fabricated, such as by etching or deposition in the z-direction. Alignment marks 120 and 122 may be the same or different. Alignment marks 120 and 122 may be a multi-directional alignment mark, i.e., capable of determining alignment in more than one direction, such as a bi-direction alignment mark, an example of which is shown as mark 120 in Figure 1D. The alignment mark 120 and/or alignment mark 122 may be a fine alignment mark, such as for alignment in the µm scale. The alignment mark 120 may be located on the donor die 102 while the target die 104 may have an alignment mark 122 located in a waste area, or vice versa. Alternatively or additionally, one or more electrically active and/or doped areas of the donor die 102 or one or more electrically active and/or doped areas of the target die 104 (not shown in Figure 1D) or other surface features may function as a reference for alignment (e.g., an alignment mark) of the donor die 102 and/or the target die 104. In addition or alternatively, a level system may be provided that is configured to measure a height and/or orientation of the one or more semiconductor dies to enable the proper alignment of a bonding surface of a donor die 102 with a bonding surface of a target die 104.

The donor die 102 and the target die 104 may be aligned in up to three dimensions before or during contact between the donor die 102 and the target die 104. For example, the donor die 102 or the target die 104 may be positioned in the x-y plane as the donor die 102 in the target die 104 are contacted. The donor die 102 or the target die 104 may be positioned by operation of a die actuator or other die-scale elements, such as by piezoelectric stepper elements, or by operation of a chuck or other carrier structure-scale elements, such as by a motor or other actuator. The position of the donor die 102 or the target die 104 may be adjusted with respect to up to six degrees of freedom. For example, given an origin point at a central part of the donor die 102, the donor die 102 may be positioned by movement along the X axis (e.g., in a positive or negative X direction), along the y-axis (e.g. in a positive or negative Y direction), along the z-axis (e.g., in a positive or negative Z direction). The donor die 102 may also be positioned rotationally with respect to each of those axes-e.g., rotated with respect to the x-axis, rotated with respect to the y-axis, rotated with respect to the z-axis. That is, the donor die 102 may be positioned by free movement in space accounted for by six different types of movement (where the movements listed above are provided as examples but where the movements may be described by other axes). Of course, the target die 104 may be positioned alone or combined with positioning of the donor die 102. Positioning or adjustment of position herein, unless the context otherwise requires, includes displacement, rotation or any combination thereof.

In some embodiments, the donor die 102 and the target die 104 may be measured with respect to a reference plane or structure (e.g., the X-Y plane), including with respect to the same reference plane or structure, but the donor die 102 or the target die 104 may be flipped (before or after measurement) so that the fabrication surface of the donor die 102 and the fabrication surface of the target die 104 may be bonded (see, e.g., the bottom diagram of Figure 1D). The one or more alignment marks (e.g., the alignment marks 120 and 122) may be on the fabrication surface of the donor die 102 and the target die 104, respectively. Once the donor die 102 or the target die 104 is flipped, one or more alignment mark may be rendered invisible (such as due to opacity of a die) to an alignment measurement tool. The alignment of the flipped die may therefore be performed based on previously measured positions of the die (e.g., of the one or more alignment marks of the die) with respect to a structure, such as the donor die 102 with respect to the carrier structure 114 or such as the target die 104 with respect to the carrier structure 116.

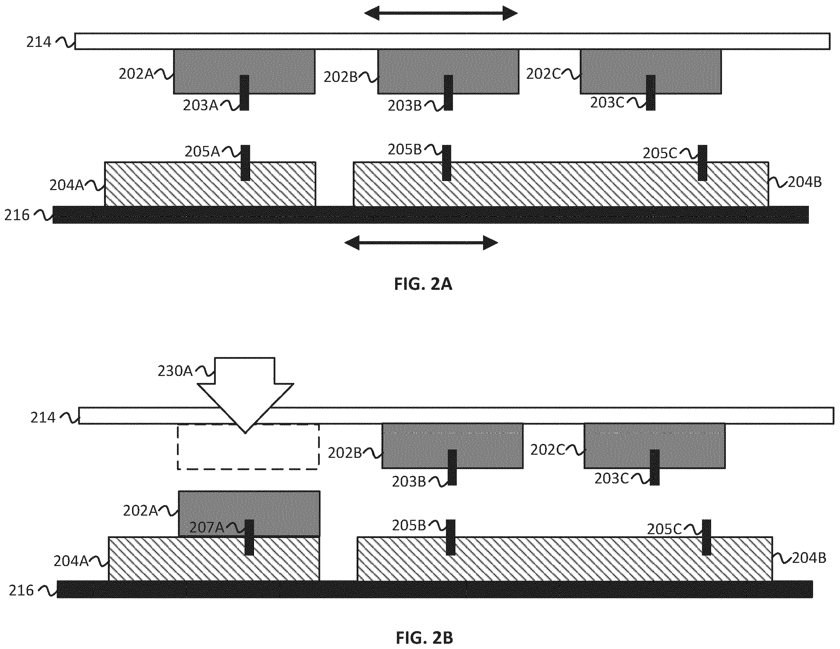

Figures 2A-2F are schematic diagrams illustrating an example method of die placement. Figures 2A-2F are described with reference to "donor die" (and "donor substrate" containing multiple "donor die") and "target die" (and "target substrate" containing multiple "target die"), which are relative descriptors and donor die may instead be target die and vice versa. Figures 2A-2F are described with respect to donor die and target die, but may instead be a donor substrate or target substrate, where a "substrate" may contain multiple "die", including un-diced (e.g., unseparated) die in the form of all or part of a semiconductor wafer. Figure 2A-2F are cross-sectional views of die placement of donor dies (e.g., donor die 202A, 202B, 202C) on target dies (e.g., target die 204A and target die 204B). In some embodiments, multiple steps which are depicted as occurring substantially simultaneously in Figures 2A-2F may be performed sequentially. In some embodiments, multiple steps which are depicted as occurring sequentially in Figures 2A-2F may be performed substantially simultaneously. In some embodiments, multiple donor dies may be aligned or placed on their respective target dies substantially simultaneously, including donor dies which are proximate (including adjacent) or distant (e.g., non-adjacent but within the same target substrate). In some embodiments, steps may be performed in a different order.

Figure 2A is a cross-sectional view of donor dies 202A-202C which are to be placed on target dies 204A-204B. The donor dies 202A-202C are supported by a carrier structure 214. The donor dies 202A-202C may be adhered to the carrier structure 214 in any appropriate manner, such as by vacuum adhesion, electrostatic adhesion, intermolecular adhesion, mechanical interlocking, surface reaction, static friction, gravitational force, etc. The donor dies 202A-202C may be adhered to the carrier structure 214 by use of an adhesive (e.g., glue), such as an organic, polymer glue. The carrier structure 214 may be a transparent substrate, such as glass, sapphire, polymer, etc. substrate. The donor dies 202A-202C may be placed on the carrier structure 214 by any appropriate method, such as by a pick and place tool. The carrier structure 214 may be supported by a chuck or any other appropriate support structure.

The target dies 204A-204B are supported by a support structure 216. In an embodiment, the target dies 204A-204B may be part of an undiced or partially diced target wafer. The target dies 204A-204B may be adhered to the support structure 216 in any appropriate manner, such as by vacuum adhesion, electrostatic adhesion, intermolecular adhesion, mechanical interlocking, surface reaction, static friction, gravitational force, etc. The target dies 204A-204B may be adhered to the support structure 216 by use of an adhesive (e.g., glue), such as an organic, polymer glue. In an embodiment, where, for example, the target dies 204A-204B are diced die, the support structure may be a carrier structure (e.g., like carrier structure 214) and may be a transparent substrate, such as glass, sapphire, polymer, etc. substrate. The target dies 204A-204B may be placed on the support structure 216 by any appropriate method, such as by a pick and place tool. The support structure 216 may be, or may be supported by, a chuck or any other appropriate structure.

The donor dies 202A-202C and the target dies 204A-204B may be aligned with one another at alignment points 203A and 205A (for donor die 202A and target die 204A), alignment points 203B and 205B (for donor die 202B and target die 204B), and alignment points 203C and 205C (for donor die 202C and target die 204B). In some embodiments, multiple donor die may be placed on a single target die, and vice versa, such as depending on integration goals. The alignment points 203A-203C are depicted for the donor dies 202A-202C, while the alignment points 205A-205C are depicted for the target dies 204A-204B. These alignment points are provided for ease of description only and need not be physical features. There may be multiple alignment points per die. The alignment points may be alignment marks (for example, the alignment marks of Figure 1D), die edges, die corners, other features on edges or surfaces of a die. The alignment points may be used to align donor and target die, such as by measurement of the locations of various alignment points and then adjustment of the position of the donor and/or target die, such as by movement of a carrier structure supporting the die, to align an alignment point of the donor die with an alignment point of the target die (or vice versa). The alignment points may be aligned directly to one another (e.g., as depicted in Figures 2A-2F). In some embodiments, the alignment points may be aligned relative to one another (e.g., in a predetermined relationship, such as separated by a vector), such as depicted in the bottom of Figure 1D, where the alignment marks are non-overlapping.

In Figure 2A, the carrier structure 214 and/or the support structure 216 may be positioned, such as in the X-Y plane, in order to align the alignment point 203A of the donor die 202A with the alignment point 205A of the target die 204A.

In Figure 2B, the donor die 202A may be released from the carrier structure 214 by any appropriate mechanism, such as release mechanism 230A. The donor die 202A meets the target die 204A at alignment point 207A. The release of the donor die 202A may be facilitated by gravity, by electrostatic forces, by physical forces, etc. The alignment of the donor die 202A and the target die 204A at the alignment point 207A (which represents a combination of the alignment point 203A and the alignment point 205A of Figure 2A) may be assisted by any appropriate alignment mechanism, including self-alignment (e.g., attraction of one area of the donor die 202A to a corresponding area of the target die 204A). In an embodiment, the release occurs while donor die 202A is in (at least partial) contact with target die 204A. In an embodiment, the release occurs before donor die 202A is in contact with the target die 204A.

The bonding between the donor die 202A and the target die 204A may be affected by a topography of a surface (e.g., flatness) of the bonding surfaces of the donor die 202A and the target die 204A, which will be discussed in more detail in reference to Figures 4A-4D.

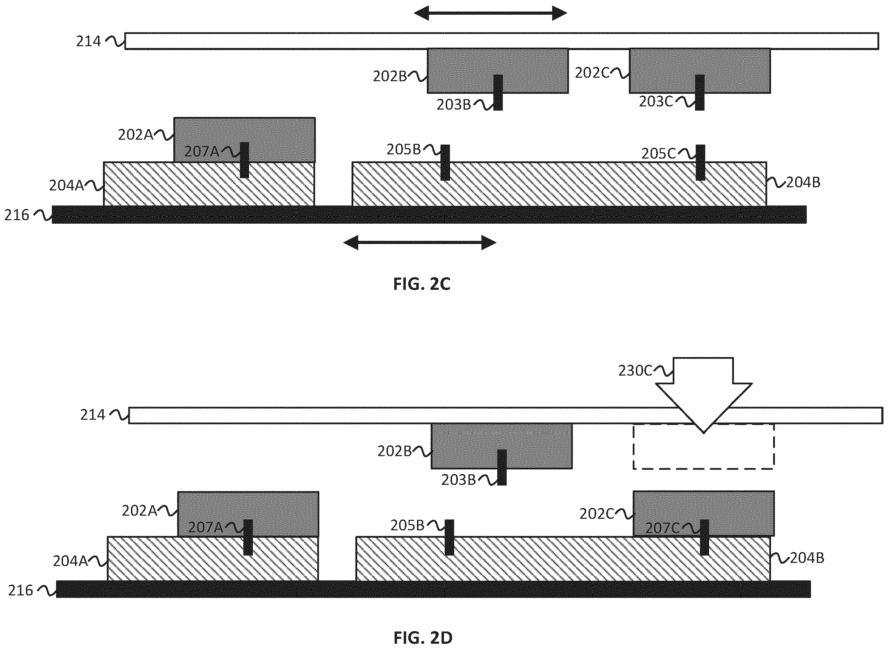

In Figure 2C, the carrier structure 214 and alternately or additionally the support structure 216 may be moved to bring another donor die (e.g., the donor die 202C) into alignment with another target die (e.g., the target die 204B). The alignment of alignment point 203C (of donor die 202C) and alignment point 205C (of target die 204B) may be based on measurements of the relative positions of the alignment points (such as using an alignment mark or feature on a die or carrier structure, using a position of an alignment point on another donor or target die, etc.). The alignment of alignment point 203C (of donor die 202C) and alignment point 205C (of target die 204B) may be based on one or more substantially simultaneous measurement of the relative positions of an alignment point, such as using an alignment mark or feature of a die or carrier structure, using an alignment target or feature of another donor or target die, etc. Although alignment of only one donor die (e.g., the donor die 202C) and target die (e.g., the target die 204B) is depicted, alignment of one or more sets of donor and target dies may occur substantially simultaneously, such as if for a given relative position of the carrier structure 214 and the support structure 216 the alignment points of multiple donor dies are aligned with the alignment points of multiple target dies. However, the ability to place multiple donor dies substantially simultaneously may depend on the placement of the donor dies on the carrier structure 214 and the ability of the release mechanism to release multiple donor dies.

In Figure 2D, the donor die 202C may be released from the carrier structure 214 by any appropriate mechanism, such as release mechanism 230C. The donor die 202C meets the target die 204B at alignment point 207C. The release of the donor die 202C may be facilitated by gravity, by electrostatic forces, by physical forces, etc. The alignment of the donor die 202C and the target die 204B at the alignment point 207C (which represents a combination of the alignment point 203C and the alignment point 205C of Figure 2A) may be assisted by any appropriate alignment mechanism, including self-alignment. In an embodiment, the release occurs while donor die 202B is in (at least partial) contact with target die 204B. In an embodiment, the release occurs before donor die 202B is in contact with the target die 204B.

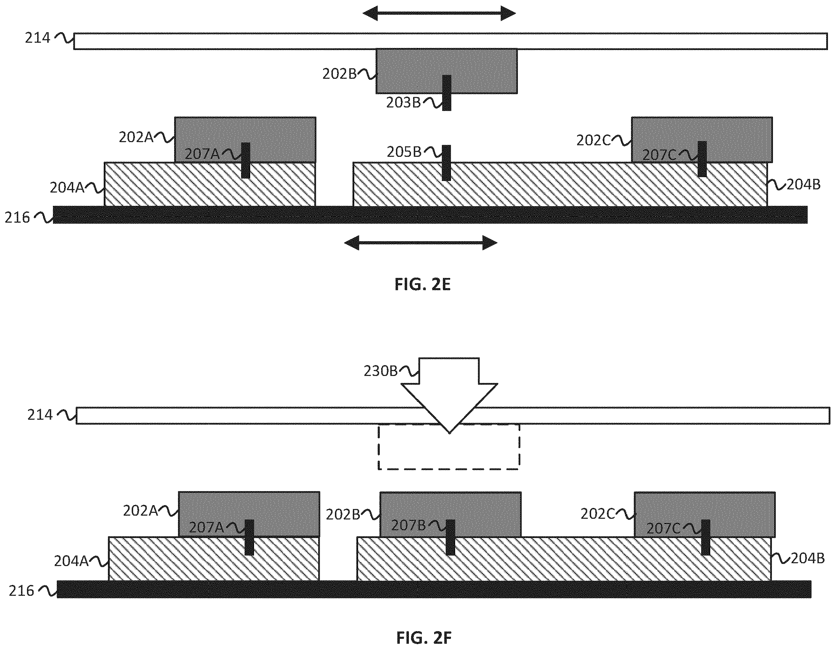

In Figure 2E, the carrier structure 214 and alternately or additionally the support structure 216 may be moved to bring another donor die (e.g., the donor die 202B) into alignment with another target die (e.g., the target die 204B). The alignment of alignment point 203B (of donor die 202B) and alignment point 205B (of target die 204B) may be based on previous measurements of the relative positions of the alignment points (such as using an alignment mark on a die or carrier structure, using an alignment point on another donor or target die, etc.). The alignment of alignment point 203B (of donor die 202B) and alignment point 205B (of target die 204B) may be based on one or more substantially simultaneous measurement of the relative positions of an alignment point, such as using an alignment mark or feature of a die or carrier structure, using an alignment target or feature of another donor or target die, etc. As depicted, the donor die 202B and the donor die 202C are aligned to the same target die (e.g., the target die 204B). In some embodiments, the donor die are placed on the target die in a substantially one-to-one relationship (e.g., as depicted for the donor die 202A and the target die 204A). In some embodiments, multiple donor die (or target die) may be placed on the same target die (or donor die). In some embodiments, multiple donor die (or target die) may be placed on un-diced (e.g., unseparated) target die (or donor die), such as all or part of a substrate containing target die (or donor die). In some embodiments, a donor die may be placed on a target die that has multiple die, including stacked (e.g., bonded) die, such as in a three layer die bonding stack.

In Figure 2F, the donor die 202B may be released from the carrier structure 214 by any appropriate mechanism, such as release mechanism 230B. The donor die 202B meets the target die 204B at alignment point 207B. The release of the donor die 202B may be facilitated by gravity, by electrostatic forces, by physical forces, etc. The alignment of the donor die 202B and the target die 204B at the alignment point 207B (which represents a combination of the alignment point 203B and the alignment point 205B of Figure 2A) may be assisted by any appropriate alignment mechanism, including self-alignment. In an embodiment, the release occurs while donor die 202B is in (at least partial) contact with target die 204B. In an embodiment, the release occurs before donor die 202B is in contact with the target die 204B.

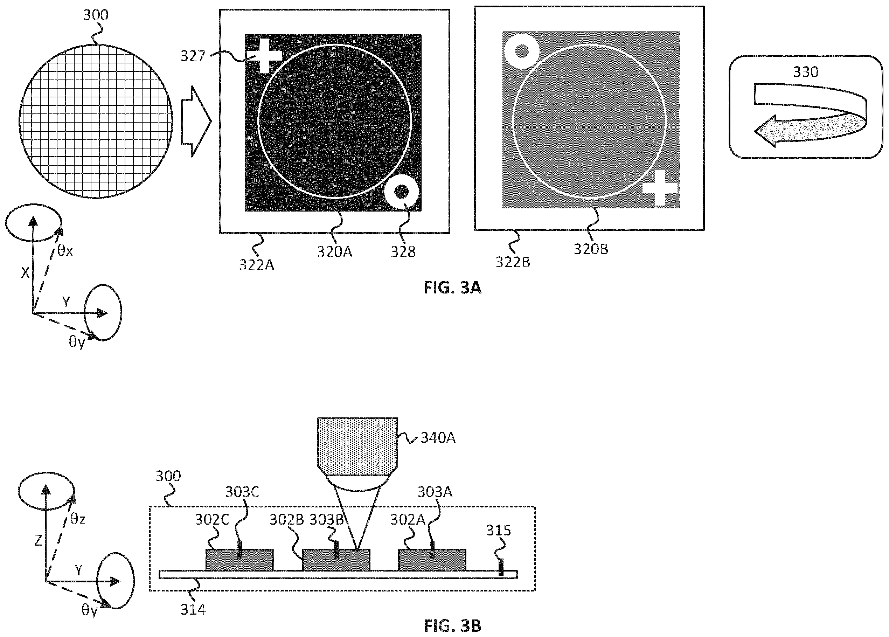

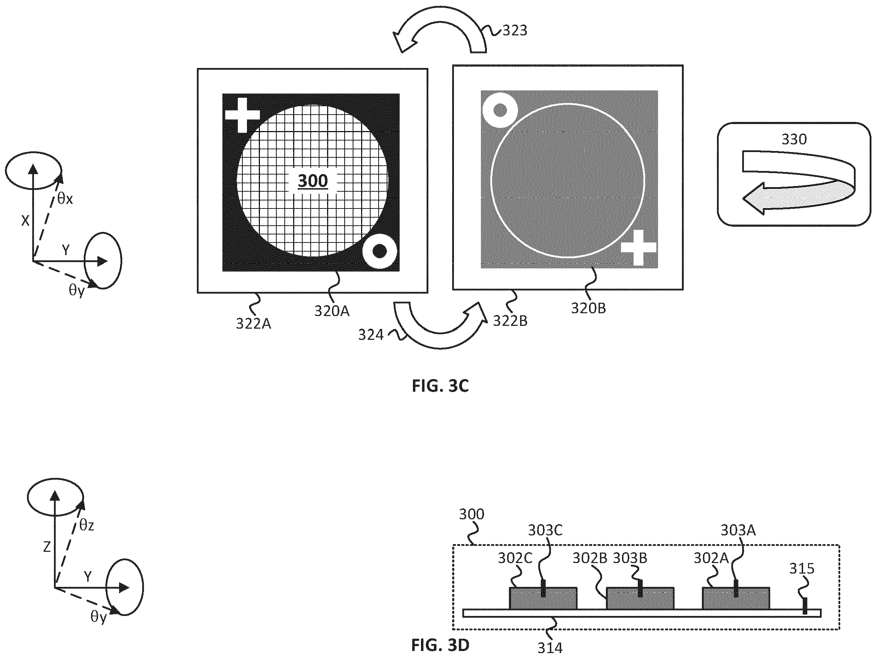

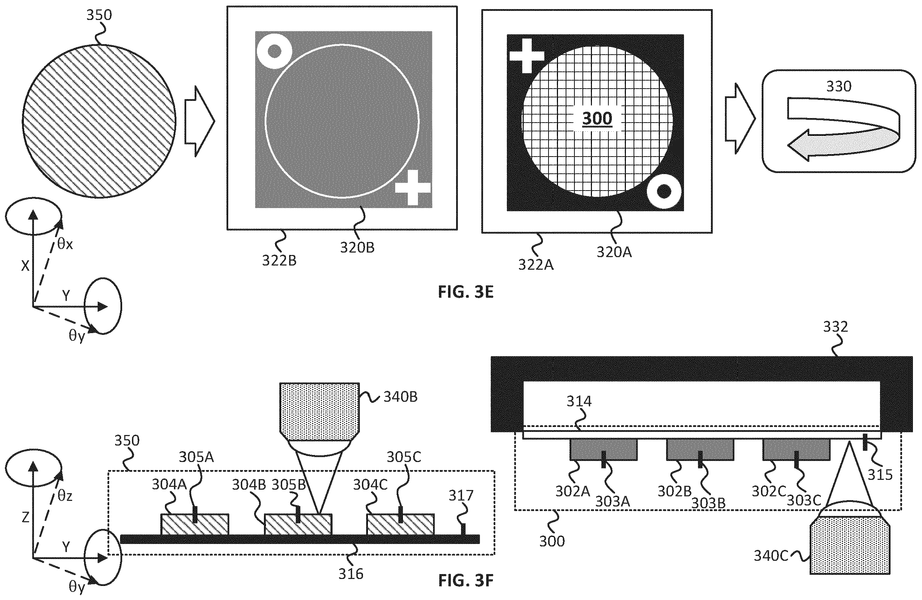

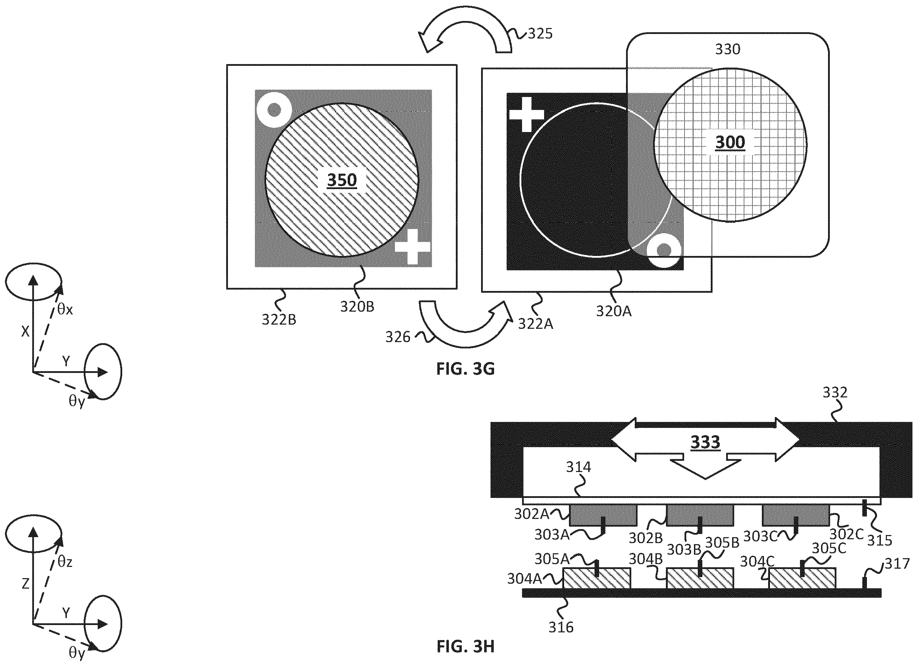

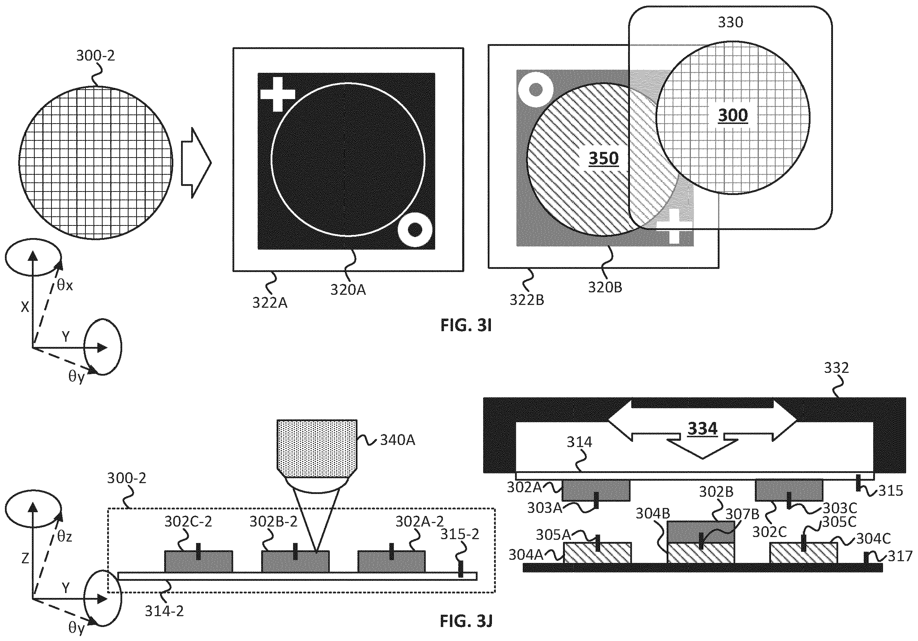

Figures 3A-3J are schematic diagrams illustrating portions of an example apparatus for die bonding. Figures 3A-3J are described with reference to "donor die" and "target die", which are relative descriptors as used herein and donor die may instead be target die and vice versa. Each of Figures 3A, 3C, 3E, 3G, and 3I is a plane view of an apparatus during placement of donor die on the target die. Each of Figures 3B, 3D, 3F, 3H, and 3J is a cross-sectional view of the apparatus during placement of donor die on the target die. The views of the apparatus in various figures represent different operations of the apparatus, but operations depicted as occurring in different figures may occur at different times or may instead be performed simultaneously and operations depicted as occurring in the same figure may instead be performed individually or at different times. A donor substrate 300 and a target substrate 350 are depicted as circular, but may instead be any appropriate shape, including rectangular, square, etc. The donor substrate 300 (and target substrate 350) may be the substrate in or on which the donor die (target die) have been formed. The donor substrate 300 (target substrate 350) may be a "reconstructed wafer", in which donor die (target die) (or other disparate portions of a semiconductor substrate) are arranged or supported on a carrier structure, e.g., to be in position suitable for die bonding. So, the donor substrate 300 (target substrate 350) may be a carrier structure and donor die (target die), where the donor die (target die) may be held (e.g., adhered) to the carrier structure by any appropriate method, such as by gravitational force, by adhesive (e.g., organic, polymer adhesive), by electrostatic forces, etc. The donor substrate 300 (target substrate 350) may contain previously tested donor die (target die), such as donor die (target die) that passed a failure analysis or other post fabrication testing. The donor substrate 300 (target substrate 350) may contain donor die (target die) from the same or different semiconductor substrates (e.g., fabrication substrates), including donor die (target die) of different types, different dimensions, etc. The donor substrate 300 (target substrate 350) may have donor die (target die) placed on the donor substrate 300 (target substrate 350) by any appropriate method, such as a pick and place tool. The donor substrate 300 (target substrate 350) may be supported, such as by a carrier structure, vacuum chuck, electrostatic chuck, etc., by either a top side (e.g., fabrication face) or backside (e.g., bulk substrate or carrier structure face) or by different faces at various points. The donor substrate 300 or donor die (target substrate 350 or target die) may have fabricated devices on multiple faces, such as through silicon vias (TSVs), contact pads, etc., such that both a top side and backside are fabrication faces.

In Figure 3A, the donor substrate 300 may be placed on a substrate chuck 320A. The substrate chuck 320A may be an appropriate substrate chuck, such as to support the donor substrate 300 in the form of a semiconductor substrate or a carrier structure of the donor substrate 300. The substrate chuck 320A may be supported by a support structure 322A. The support structure 322A may be a moveable support structure, which may move in the X-Y plane, such as from a first position where the substrate chuck 320A receives the donor substrate 300 to a second position where the donor substrate 300 may be subjected to metrology. The substrate chuck 320A may contain (e.g., support) one or more die actuators or other mechanical or electrical actuators which may move a donor die or the donor substrate 300 in one or more dimension, including in the X-Y plane, in the Z-direction, rotationally, etc. The substrate chuck 320A may have one or more alignment marks, such as to allow a camera or other measurement system to track the position of the substrate chuck 320A. The substrate chuck 320A may have multiple sets of alignment marks, such as coarse alignment marks and/or fine alignment marks. The substrate chuck 320A may move, such as by action of the support structure 322A, from one position to another, in free space, etc. The support structure 322A may be configured to move in multiple directions and in multiple scales (e.g., in a coarse step and a fine step), such as by multiple motors or steppers. The support structure 322A may be activated by a controller of the example apparatus-where the controller of the example apparatus (not depicted) may also control the placement of the donor substrate 300 on the substrate chuck 320A and other operations described herein.

The substrate chuck 320A may have a measurement point (or alignment point), such as identified by a cruciform measurement mark 327 and a round zero measurement mark 328, which are provided merely as examples and where any appropriate zero measurement mark may be used. The measurement point may be used to place the donor substrate 300 on the substrate chuck 320A, such as during movement of the substrate onto the chuck (for example, by insertion of the donor substrate by a substrate handler). The measurement point may be used to measure relative positions of the donor die of the donor substrate 300 once the donor substrate 300 is placed on the substrate chuck 320A. The placement of the donor die may be measured, such as with up to nm precision, with respect to the measurement point. The measurement of the position of the donor die after their placement may be obtained from any appropriate measurement system, such as optical microscopy, reflectometry, etc.

Figure 3A also depicts a further substrate chuck 320B on a support structure 322B. The substrate chuck 320B may be any appropriate substrate chuck, such as substantially identical to the substrate chuck 320A. The support structure 322B may be any appropriate support structure, such as substantially identical to the support structure 322A. In some embodiments, the substrate chuck 320B and the substrate chuck 320A may be substantially indistinguishable. In some embodiments, the support structure 322B and the support structure 322A may be substantially indistinguishable. Although two substrate chucks and two support structures are depicted, in some embodiments more or less substrate chucks and support structures may be present in the apparatus. Operations depicted as performed by the substrate chuck 320B (substrate chuck 320A) may instead or additionally be performed by any appropriate substrate chuck. Likewise, operations depicted as performed by the support structure 322B (support structure 322A) may instead or additionally be performed by any appropriate support structure.

Figure 3A also depicts flipper 330. The flipper 330 may be any appropriate apparatus which may flip a substrate (e.g., donor substrate 300), such as about the longitudinal axis or plane of the donor substrate 300 depicted in Figure 3A. The flipper 330 will be described in more detail in reference to Figures 3E and 3F.

In Figure 3B, a cross-sectional view of a donor substrate 300 is depicted. The donor substrate 300 comprises a carrier structure 314 which supports one or more donor die (e.g., donor die 302A-302C). The substrate may have one or more alignment points, such as alignment point 315, used to measure a relative position of the donor die 302A-302C with respect to the carrier structure. The donor die may have alignment points, such as alignment points 303A-303C for donor die 302A-302C, respectively. The alignment points are provided as schematic representations in these drawings for ease of description, and may be any appropriate alignment points, including alignment marks, fabricated features, edge features, etc., as previously described. While the donor substrate 300 is on a substrate chuck (e.g., the substrate chuck 320A of Figure 3A), the positions of the donor die (e.g., the donor die 302A-302C) are measured, such as by metrology tool 340A. The positions may be measured as absolute positions, relative positions, positions relative to other die, positions relative to an alignment point of the substrate, etc. The measured positions may be stored by a controller of the apparatus, such as for later positioning of the donor substrate 300. The metrology tool 340A may be a camera, including a still camera, a video camera, etc. The metrology tool 340A may be any appropriate tool for measurement of a position of a donor die, measurement of a position of an alignment point of the donor die, measurement of a position of alignment mark of the donor die, etc.

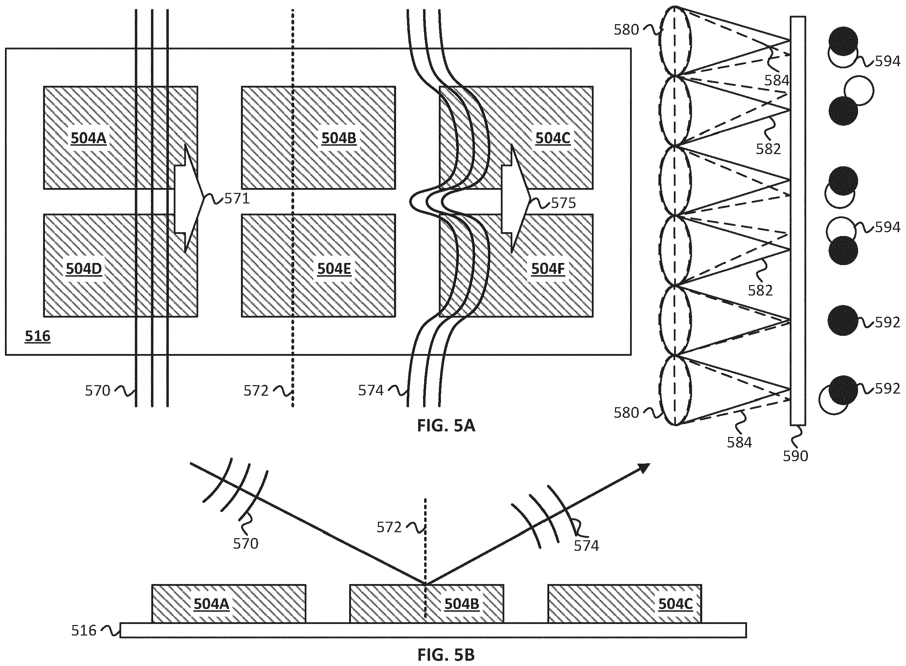

While the donor substrate 300 is on a substrate chuck (e.g., the substrate chuck 320A of Figure 3A), the topography of a surface (e.g., surface flatness) of the donor die (e.g., the donor die 302A-302C) may be qualified, such as by metrology tool 340A or another appropriate metrology tool such as a sensor to detect a characteristic of a topography of a surface of a die, such as will be described in reference to Figures 5A-5C. In some embodiments, the metrology tool 340A may contain the sensor to detect a characteristic of a topography of a surface of a die (e.g., a flatness sensor).

The topography of a surface can be a function of the material that forms the surface (e.g., surface roughness, imperfections in flatness, etc.), of something that comes onto the surface (e.g., a contamination such as particles) and/or of a shift in displacement, orientation, etc. of the surface (e.g., tilt of the surface). A characteristic of the topography may be measured in any appropriate granularity, such as one measurement per die, multiple measurements per die, one measurement per micron, one measurement per ten microns, etc. The topography may be quantified per die, per donor substrate 300, etc. The topography may be measured relative to the carrier structure 314, to the substrate chuck 320A, to the support structure 322A, to a plane of a tool (e.g., on which the support structure 322A rests), etc. The topography measurement may arrive at a characteristic of the topography such as a flatness measurement, surface profile, surface roughness, tilt, convexity, concavity, particle presence and/or absence, protrusion presence and/or absence, etc. The topography measurement may account for recessed areas of the donor die 302A-302C. In some embodiments, the topography measurement may measure flatness of recessed areas. In some embodiments, the topography measurement may measure flatness of bonding surfaces, which may not include recessed areas. The measured characteristic of each die may be stored by a controller of the apparatus, such as for later selecting of the die for bonding and/or rejecting of the die for bonding. In some embodiments, one or more dies which fail to meet a threshold (e.g., a minimum value) for the topography characteristic may be rejected for die bonding. These one or more dies may be removed from the carrier structure 314 before die bonding of one or more other dies, in some embodiments. In some embodiments, rejected one or more dies may be left on the carrier structure 314 while other one or more dies are bonded but the rejected one or more dies are not selected themselves for bonding to a specific target location. In some embodiments, the one or more dies which fail to meet a threshold for the topography characteristic may be rejected for bonding and selected for re-cleaning, re-positioning, or another re-processing step before being processed for die bonding again. Alternatively or additionally, the topography characteristic of a die may be measured (e.g., quantified) at any appropriate point, such as when the donor dies 302A-302C are placed on the carrier structure 314, before release of one or more donor dies from the carrier structure (such as depicted in Figure 3J), etc. The topography characteristic may be measured (e.g., quantified) at multiple points in the process.

In Figure 3C, the donor substrate 300 is supported by the substrate chuck 320A, which is supported by the support structure 322A. Once the position of the donor dies are measured, the substrate chuck 320A may be moved, such as out of the measurement position. The support structure 322A may move (e.g., along direction 324) to the position of the support structure 322B, while the support structure 322B may move (e.g., along direction 323) to the position of the support structure 322A. The positions are provided as examples, and the support structures may move to different positions. For example, in some embodiments, the support structure 322B may move to a loading position, such as to receive a target substrate (e.g., the target substrate 350). The substrate chuck 320A may then occupy another position in the apparatus (e.g., a bonding position, a flipping position, etc.). The position the substrate chuck 320A moves to after measurement of the positions of the donor die (e.g., after the measurement depicted in Figure 3B) may be configured to allow the flipper 330 to accept the donor substrate 300 from the substrate chuck 320A.

In Figure 3D, the movement of the donor substrate 300 to a position other than the measurement position of Figure 3B is depicted. The movement may correspond to the movement of the donor substrate 300 in the direction 324, such as by movement of the support structure 322A, of Figure 3C. This figure is provided to show continuity of the die bonding process in both plane and cross-sectional views, but may occur substantially simultaneously with the process depicted in Figure 3C or Figure 3E, where, as previously described, steps which are depicted as occurring separately, including sequentially, may be performed substantially simultaneously.

In Figure 3E, the target substrate 350 may be placed on a substrate chuck 320B. The substrate chuck 320B may be an appropriate substrate chuck, as previously described. The substrate chuck may be supported by a support structure 322B, which may be any appropriate support structure, as previously described.

In Figure 3E, the donor substrate 300 may be transferred to the flipper 330. The flipper 330 may accept (e.g., take) the donor substrate from the substrate chuck 320A, such as by use of edge clamps, vacuum clamps, finger prongs, etc. The flipper 330 may hold the donor substrate by one or more edges (e.g., one or more edges of the carrier structure 314) or one or more sides (for example, a backside of the carrier structure 314 which does not support the donor die). The flipper 330 may rotate the donor substrate 300 upside down (e.g., with respect to the direction of the gravitational force). The flipper 330 may hold the donor substrate 300 upside down (e.g., opposite to) with respect to the X-Y plane which it previously occupied-or in any other appropriate direction. The flipper 330 may hold the donor substrate 300 or place the donor substrate 300 into a support structure, such that the donor substrate 300 faces the plane of the target substrate 350. The flipper 330 may rotate or displace the donor substrate 300 in the X-Y plane, as well as displace or rotate the donor substrate 300 out of the X-Y plane. The flipper 330 may be any appropriate rotational or translational apparatus.

In Figure 3F, a cross-sectional view of the target substrate 350 is depicted. The target substrate 350 comprises a carrier structure 316 which supports one or more target dies (e.g., target die 304A-304C). The substrate may have one or more alignment points, such as alignment point 317. The target die may have alignment points, such as alignment points 305A-305C for target die 304A-304C, respectively. The alignment points are provided as schematic representations in these drawings for ease of description, and may be any appropriate alignment points, including alignment marks, fabricated features, edge features, etc., as previously described. While the target substrate 350 is on the substrate chuck (e.g., the substrate chuck 320B of Figure 3E), the positions of the one or more target dies (e.g., the target die 304A-304C) are measured, such as by metrology tool 340B. The metrology tool 340B may be the same as the metrology tool 340A used to measure the positions of the one or more donor dies (e.g., the donor die 302A-302C of Figure 3B) or a different metrology tool. The metrology tool 340B may measure a different number of positions, substantially different positions (e.g., arranged differently on the target substrate 300 than the positions on the donor substrate 300 as measured by the metrology tool 340A), different positions relative to dies (e.g., the donor die 302A-302C versus the target die 304A-304C), etc. than the metrology tool 340A. The positions may be measured as absolute positions, relative positions, positions relative to other die, positions relative to an alignment point of the substrate, etc. The measured positions may be stored by a controller of the apparatus, such as for later positioning of the target substrate 350. The metrology tool 340B may be a camera, including a still camera, a video camera, etc. The metrology tool 340B may be any appropriate tool for measurement of a position of a donor die, measurement of a position of an alignment point of the donor die, measurement of a position of alignment mark of the donor die, etc. The target substrate 350 may experience deformation due to the holding by a substrate chuck, etc. The metrology tool 340B may also enable determination of deformation of the target substrate by measuring locations. A controller may determine the deformation of the target substrate 350 based on those measured locations (e.g., from curve fitting, using a physical deformation model, etc.).

While the target substrate 350 is on a substrate chuck (e.g., the substrate chuck 320B of Figure 3E), the topography (e.g., flatness) of a surface of the target die (e.g., the target die 304A-304C) may be qualified, such as by metrology tool 340B or another appropriate metrology tool such as a sensor to detect a characteristic of a topography of a surface of a die (which may be the same, or a different sensor, to the sensor to detect a characteristic of a topography of a surface of a die described in relation to Figure 3B), such as will be described in reference to Figures 5A-5C. In some embodiments, the metrology tool 340B may contain the sensor to detect a characteristic of a topography of a surface of a die (e.g., a flatness sensor).

A characteristic of the topography may be measured in any appropriate granularity, such as one measurement per die, multiple measurements per die, one measurement per micron, one measurement per ten microns, etc. The topography may be quantified per die, per target substrate 350, etc. The topography may be measured relative to the carrier structure 316, to the substrate chuck 320B, to the support structure 322B, to a plane of a tool (e.g., on which the support structure 322B rests), etc. The topography measurement may arrive at a characteristic of the topography such as a flatness measurement, surface profile, surface roughness, tilt, convexity, concavity, particle presence and/or absence, protrusion presence and/or absence, etc. The topography measurement may account for recessed areas of the target dies 304A-304C. In some embodiments, the surface topography measurement may measure flatness of recessed areas. In some embodiments, the topography measurement may measure flatness of bonding surfaces, which may not include recessed areas. The measured characteristic of the topography of the surface of each die may be stored by a controller of the apparatus, such as for later selecting of the die for bonding and/or rejecting of the die for bonding. In some embodiments, one or more dies which fail to meet a threshold (e.g., a minimum value) for the topography characteristic may be rejected for die bonding. These one or more dies may be removed from the carrier structure 316 before die bonding of one or more other dies, in some embodiments. In some embodiments, rejected one or more dies may be left on the carrier structure 316 while other one or more dies are bonded but the rejected one or more dies are not selected themselves for bonding to a specific target location. In some embodiments, the one or more dies which fail to meet a threshold for the topography characteristic may be rejected for bonding and selected for re-cleaning, re-positioning, or another re-processing step before being processed for die bonding again. In some embodiments, the same or different number of topography characteristic measurements may be made for one or more target dies (e.g., the target dies 304A-304C) as one or more donor dies (e.g., the one or more donor dies 302A-302C as described with respect to Figure 3B). In some embodiments, if the target die (e.g., one or more target dies 304A-304C) is integrated into a wafer (e.g., undiced), the target die may experience fewer topography measurements than the donor die because the target die may be assumed to be un-tilted with respect its carrier. In some embodiments, an undiced wafer containing the target die (e.g., the target die 304A-304C) may be subjected to substantially the same number of measurements as a diced die (e.g., as donor dies 302A-302C)-such as where the primary effect sought to be quantified by the measurements is the presence or absence of surface particles. Alternatively or additionally, the topography characteristic of a die may be measured (e.g., quantified) at any appropriate point, such as when the one or more target dies 304A-304C are placed on a carrier structure 316, before release of a donor die from a carrier structure (such as depicted in Figure 3J), etc. The topography characteristic may be measured (e.g., quantified) at multiple points in the process.

In Figure 3F, the donor substrate 300 is supported by a bonding support structure 332. The bonding support structure 332 may be part of the flipper 330 (of Figure 3E) or the donor substrate 300 may be placed into the bonding support structure 332 by the flipper 330. The bonding support structure 332 may hold the donor substrate 300 opposite to a plane of the target substrate 350. The bonding support structure 332 may hold the donor substrate by the carrier structure 314, including by one or more edges of the carrier structure 314. While in the bonding support structure 332, the position of the donor substrate 300 may be measured, such as by metrology tool 340C, to enable, for example, relative positioning between the donor substrate 300 and the target substrate 350. The metrology tool 340C may be any appropriate metrology tool. The metrology tool 340C may measure locations of the donor die (e.g., the donor die 302A-302C), locations of the alignment point 315, etc. The metrology tool 340C may measure significantly fewer locations than the metrology tool 340A or 340B, and the controller may determine the position of the target substrate 350 based on those fewer locations (e.g., from curve fitting, using physical deformation models, etc.). The controller may determine updated positions for the donor die (e.g., the donor die 302A-302C) based on a combination of the measured locations of the donor die 302A-302C (such as from Figure 3B) and the measured position of the donor substrate 300. The donor substrate 300 may experience deformation due to holding by a substrate chuck, the movement of the flipper 330, suspension from the bonding support structure 332, etc. The metrology tool 340C may also enable determination of deformation of the donor substrate by measuring locations. As noted above, the metrology tool 340C may measure significantly fewer locations than the metrology tools 340A and 340B, and the controller may determine the deformation of the donor substrate 300 based on those fewer locations (e.g., from curve fitting, using a physical deformation model, etc.) than those measured by the metrology tool 340A on the donor substrate 300 or by metrology tool 340B on the target substrate 350.

In Figure 3G, the target substrate 350 is supported by the substrate chuck 320B, which is supported by the support structure 322B. Once the position of the target dies are measured, the substrate chuck 320B may be moved, such as to align with the donor substrate 300 supported by the flipper (e.g., supported by the bonding support structure 332 of Figure 3F). The support structure 322B may move (e.g., along direction 326) to the position of the support structure 322A, while the support structure 322A may move (e.g., along direction 325) to the position of the support structure 322B. The positions are provided as examples, and the support structures may move to different positions. For example, in some embodiments, the support structure 322A may move to a loading position, such as to receive an additional target substrate (e.g., the target substrate 350). The substrate chuck 320B may then occupy another position in the apparatus (e.g., a bonding position). The position the substrate chuck 320B moves to after measurement of the positions of the target die (e.g., after the measurement depicted in Figure 3F) may be configured to place a donor die of the donor substrate 300 onto the target die of the target substrate 350. The substrate chuck 320B may be aligned with the donor substrate 300 in the flipper 330, which may be held above the plane of the substrate chuck 320B (as depicted in Figure 3G for a top down view in which the donor substrate 300 is at least partially above the plane of the substrate chuck 320B (e.g., obscuring the substrate chuck 320A).

In Figure 3H, the donor substrate 300 and the target substrate 350 are aligned. The donor substrate 300 may be aligned to the target substrate 350 by movement of the bonding support structure 332, such as in any of the directions or orientations 333. The target substrate 350 may be aligned with the donor substrate 300 by movement of a substrate chuck (e.g., the substrate chuck 320B of Figure 3G) or the support structure (e.g., the support structure 322B of Figure 3G). The donor substrate 300 and the target substrate 350 may be aligned to one another, including by both coarse and fine alignment, such as by alignment of the relative positions of one or more alignment point (e.g., the alignment point 315 of the donor substrate 300 and the alignment point 317 of the target substrate 350). In some embodiments, the donor substrate 300 and the target substrate 350 may be aligned, such as by coarse alignment. In some embodiments, once the donor substrate 300 and the target substrate 350 are aligned, one or more donor die of the donor substrate 300 may be aligned with one or more target die of the target substrate 350. In Figure 3H, the alignment of the donor die 302B with the target die 304B (e.g., of the alignment point 303B of donor die 302B with the alignment point 305B of target die 304B) is depicted. Once a donor die is aligned with a target die, that donor die may be placed on the target die, by any appropriate method, such as die actuator activation, gravitational acceleration, electrostatic actuation, etc.

In Figure 3I, an additional donor substrate (e.g., donor substrate 300-2 having a carrier structure 314-2) is placed on the substrate chuck 320A for additional placement of donor dies on target dies. In some embodiments, the additional donor substrate may be placed on the substrate chuck 320A after the substrate of the previous donor substrate is removed from the substrate chuck 320A-for example, if the substrate of a donor substrate is removed from the flipper 330 and re-placed on the substrate chuck 320A. In some embodiments, the previous donor substrate may be removed from the flipper 330 without recourse to the substrate chuck 320A, such as by removal from the flipper to an additional substrate chuck (not depicted) or any other appropriate removal procedure. The additional donor substrate may be placed on the substrate chuck 320A after the previous donor substrate is accepted by the flipper 330 or at any time when the substrate chuck 320A (or another substrate chuck) is free. The additional donor substrate (e.g., the donor substrate 300-2) may be substantially identical to or different from the previous donor substrate (e.g., the donor substrate 300). The processing of the donor substrate 300-2 by placement of the donor dies on target dies may proceed as previously described in relation to Figures 3A-3H, such as by placement on an additional target substrate (not depicted). The donor substrate 300-2 may be placed on the substrate chuck 320A while the donor dies of the donor substrate 300 are placed on the target dies of the target substrate 350, such as substantially simultaneously.

In Figure 3J, the positions of the donor die (e.g., the donor die 302A-2 to 302C-2) and/or of mark 315-2 are measured, as previously described in relation to Figure 3B.

In Figure 3J, additional donor die of the donor substrate 300 are placed on the target die of the target substrate 350. The position of the donor substrate 300, the target substrate 350, or a combination thereof may be adjusted to align an additional donor die of the donor substrate 300 with a target die of the target substrate 350. As depicted, the donor substrate 300 is positioned (such as by movement in the directions or orientations 334) to align the alignment point 303A of the donor die 302A with the alignment point 305A of the target die 304A. The donor die 302A may then be placed on the target die 304A by any appropriate method, such as previously described. The donor die 302B is depicted as bonded to the target die 304B, subsequent to their alignment at alignment point 307B in Figure 3H. As will be realized, the various steps of Figures 3A-H can be repeated as appropriate to bond multiple dies and process multiple donor and target substrates.

Figures 4A-4D are schematic diagrams illustrating example effects of a topography of a surface on die bonding. Figures 4A-4D are cross-sectional views of bonding of a donor die (e.g., one or more donor dies 402A-402C) to a target die (e.g., one or more target dies 404A-404C) where die bonding is hindered by, e.g., the presence of contamination (e.g., particles) and/or lack of flatness of one or more dies. Figures 4A-4D are described with reference to "donor die" and "target die", which are relative descriptors as used herein and donor die may instead be target die and vice versa. A donor die may instead be a donor substrate and a target die may instead be a target substrate and a donor die may be bonded to a target substrate, a donor substrate may be bonded to a target substrate, and a donor substrate may be bonded to a target die. Multiple donor dies may be bonded to a single target die and vice versa. Imperfections in the topography of the target die are depicted in Figures 4A-4D, but these are provided as illustrative examples only. Imperfections in the topography of the donor die may additionally or alternatively hinder die bonding. The examples depicted in Figures 4A-4D are representative but not exhaustive and other types of imperfections in a surface of a die may exist and be detected by a sensor to detect a characteristic of a topography of a surface of a die or one or more methods described herein.

In Figure 4A, target dies 404A-404C are supported by a support structure 416 (of course, there may not be a support structure and the one or more target dies 404A-404C are part of a substrate, such as a semiconductor wafer). The target dies 404A-404C are patterned die, consisting of regions constructed of bulk material 409, doped areas 412, and electrically active areas 408. These areas are provided for illustrative purposes only, and target dies 404A-404C may have alternative or additional regions. Each region of the target die 404A-404C may have different chemical, physical, electrical, etc. properties. For example, the bulk material 409 may be silicon, silicon on insulator, GaAs, etc. The doped areas 412 may consist of regions where electrical, chemical, or other properties of the bulk material 409 have been altered, such as through ion implantation, chemical vapor deposition, etc. The doped areas 412 may be regions where the bulk material 409 has been removed (such as through etching) and a different material supplied. The electrically active areas 408 may contain a metal, such as copper, titanium, etc. which may be a multi-layer metal, an alloy, or any other appropriate metal or conductive material. The electrically active areas 408 may be through silicon vias (TSVs), bit lines, word lines, voltage supply lines, etc. The material of the electrically active areas 408 may have a substantially higher thermal expansion coefficient, lower melting point, higher surface tension, etc. than the material of the other regions (e.g., the bulk material 409 and/or the material of the doped areas 412) such that upon annealing the material of the electrically active areas 408 (for example, copper) may expand to provide electrical contact to another material-such as an electrically active area of a donor die. The material of the electrically active area 408 may be any appropriate expansive material, such as appropriate for hybrid bonding.

As depicted, each of the target dies 404A-404C has at least one defect in topography of the surface for bonding (e.g., with respect to perfect flatness). Target die 404A is depicted as having particle 450 located near an electrically active area 409. The particle 450 is depicted as being large enough to cover the top of the nearest electrically active are 409. The particle 450 may have any dimension. In some embodiments, particles under a certain threshold size may be disregarded in topography qualification as they may not affect bonding. In some embodiments, particles under a certain threshold size and a certain threshold density (e.g., particles per area) may be disregarded in topography qualification as they may not affect bonding. In some embodiments, particle size and density may be measured during topography qualification. The particle 450 may cause a relatively local, sharp response in topography qualification, where the deviation from, e.g., flatness in the target die 404A may be localized to the position of the particle 450.

Target die 404B is depicted as being tilted with respect to the support structure 416. Target die 404B is depicted as lying on particle 452, where particle 452 is sandwiched between the target die 404B and the support structure 416, but any other type of defect, including a defect of the support structure 416, a defect of the bottom surface of the target die 404B, etc. may cause tilting of the target die 404B with respect to the support structure. The tilt of the target die 404B may cause a relatively large, gradual response in topography qualification, where the deviation from, e.g., flatness may be delocalized over the surface of the target die 404B.

Target die 404C is depicted as containing a bowed region 454 (e.g., a convex area corresponding to a doped area 412). The bowed region 454 may be caused by overfilling, imperfect planarization, over or under doping causing lattice strain, or any other effect. The bowed region 454 may cause a response in topography qualification of the target die 404C which corresponds to the amount and localization of the bowing.

In Figure 4B, donor dies 4042A-404C are brought into contact with the target dies 404A-404C. The donor dies 402A-402C are supported by a carrier structure 414 (of course, there may not be a support structure and the one or more target dies 404A-404C are part of a substrate). The donor dies 402A-402C are patterned die, depicted as containing regions similar to those of the target dies 404A-404C (e.g., bulk material 407, doped areas 410, and electrically active areas 406), but alternatively or additionally contain any appropriate areas for a patterned die. As described for the target dies 404A-404C, each region of the donor die 402A-402C may have different chemical, physical, electrical, etc. properties. For example, the bulk material 408 may be the same as or different from the bulk material 409. The doped areas 410 may be the same as or different from the doped areas 412 (e.g., both areas may be n doped, both areas may be p doped, doped areas 410 may be n doped while doped areas 412 are p doped, etc.). The electrically active areas 406 may contain a metal, such as copper, titanium, etc. which may be a multi-layer metal, an alloy, or any other appropriate metal or conductive material. The electrically active areas 406 may contain the same material as the electrically active areas 408. In some embodiments, the electrically active areas 406 may contain a different material than the electrically active areas 408, where the materials of both the electrically active areas 406 and the electrically active areas 408 may be annealable, such as by high temperature alloy creation (e.g., be miscible metals), or otherwise able to form electrical connections with one another through expansion. The electrically active areas 406 may be through silicon vias (TSVs), bit lines, word lines, voltage supply lines, etc. The material of the electrically active areas 406 may have a substantially higher thermal expansion coefficient, lower melting point, higher surface tension, etc. than the material of the other regions (e.g., the bulk material 407 and/or the material of the doped areas 410) such that upon annealing the material of the electrically active areas 406 (for example, copper) may expand to provide electrical contact to another material-such as an electrically active area of a target die. The material of the electrically active area 406 may be any appropriate expansive material, such as appropriate for hybrid bonding.

During bonding, the donor die 402A may be placed, by any appropriate method 460A, on the target die 404A, the donor die 402B may be placed, by any appropriate method 460B, on the target die 404B, and the donor die 404C may be placed, by any appropriate method 460C, on the target die 404C. The placement of the donor die 402A-402C on the target die 404A-404C may cause bonding of the surfaces of the respective donor die and the target die. Bonding may begin at one or more points of contact and spread outwards on one or more bonding fronts. Once bonding has begun, it may be difficult to separate the respective donor die and target die without damaging either die. The efficacy of the bonding may depend on the flatness of the bonding surfaces, the cleanliness of the bonding surface (e.g., presence or absence of particles, chemical preparation such as dangling hydrogen bonds, etc.), speed and direction of travel of the bonding front, etc.

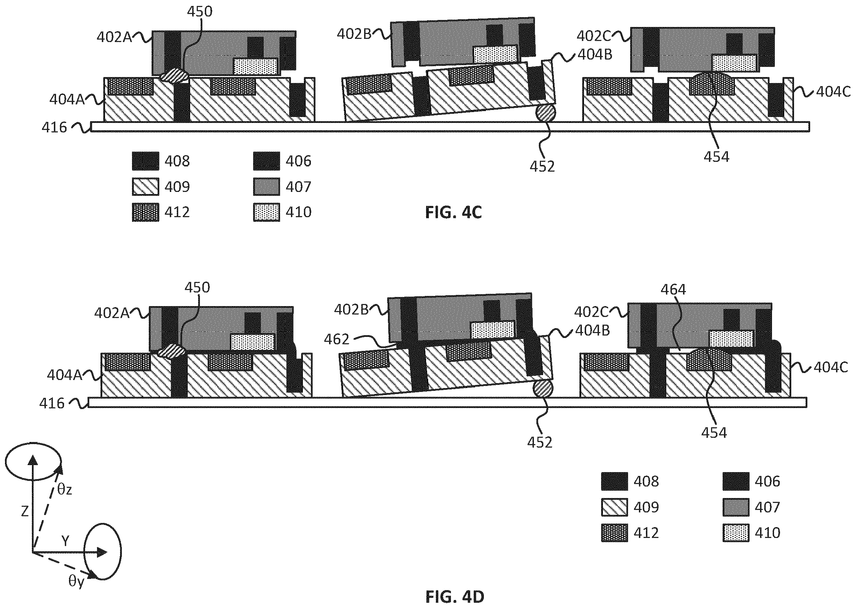

In Figure 4C, donor dies 402A-402C are bonded, or being bonded, to the target dies 404A-404C. The bonding of the donor die 402A and the target die 404A is interrupted by the presence of the particle 450. The presence of the particle 450 may prevent areas of the donor die 402A from contacting corresponding areas of the target die 404A. The presence of the particle 450 may cause bonding fronts to deviate at the particle 450 (e.g., split, deflect, curve, etc.). The presence of the particle 450 may not have an effect on the bonding (for example, if the particle 450 lies entirely within a recessed area of the donor die 402A and/or the target die 404A), but may instead affect electrical contact between the donor die 402A and the target die 404A.

The tilt of the target die 404B may affect the placement and/or bonding of the donor die 402B on the target die 404B. The tilt of the target die 404B may cause the donor die 402B to land in an unintended area of the target die 404B. The tilt of the target die 404B may cause the donor die 402B to bond to one region of the target die 404B (e.g., a closer or more prominent region), while not bonding to another region of the target die 404B (e.g., a further away region). The tilt may not allow any bonding. The tilt of the target die 404B may affect the speed and direction of a bonding front, which may not be strong enough to bond regions with greater separation caused by the tilt of the target die 404B. The bowed region 454 of the target die 404C may likewise affect bonding, where the bowed region 454 may prevent various regions of the donor die 402C and the target die 404C from coming into contact.

In Figure 4D, the donor die 402A-402C and the target die 404A-404C are depicted after annealing. For the donor die 402A and target die 404A pair, the particle 450 has obstructed electrical contact between the electrically active area 408 and the electrically active area 406, which may cause an open contact in the bonded die. For the donor die 402B and the target die 404B pair, the tilt of the target die 404B has caused an area 462 where metal (or other expansive material of the electrically active area 408 and the electrically active are 406) has filled a gap left between the die during bonding. This may cause electrical shorts, where electrical contact is made to one or more regions where it is not planned. For the donor die 402C and the target die 404C, the bowed region 454 of the target die 404C has caused a void 464, where the metal (or other expansive material of the electrically active area 408 and the electrically active are 406) has both expanded into spaces left between the die also created the void 464. The void 464 may be an area which would be an electrical short, but which the metal (or other expansive material) lacks enough volume to expand into. The void 464 may cause electrical contact issues between the die.

Figures 4A-4D are provided to illustrate some examples of the effects of topography of a surface of a die on die bonding, but should not be taken to be an exhaustive list. Other effects of undesired topography of a die surface may occur. In some embodiments, topography quantification may be significant to die bonding, where quantification of a characteristic of the topography of a surface of a die may allow for selection of a die for bonding which have a greater chance of successful bonding and therefore yielding economically viable die bonded pairs. Quantification of a characteristic of the topography of a surface of a die before bonding may be particularly valuable, as once bonding has occurred it may be approximately irreversible without damaging the die. Also, quantification of a characteristic of the topography of a surface of a die before bonding may be particularly valuable, as bonding may not be properly viable.

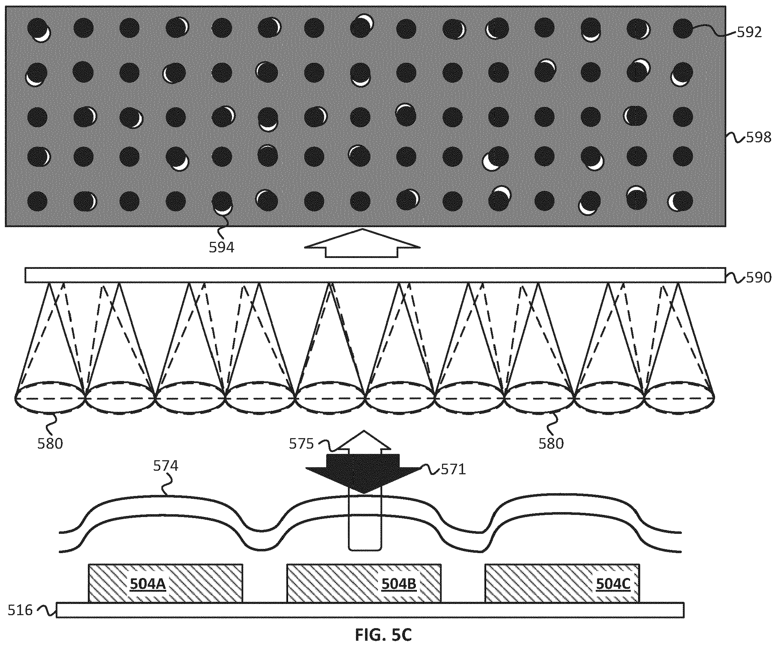

Figures 5A-5C are schematic diagrams illustrating example methods and systems for surface topography qualification of a die for, or during, die bonding. Figures 5A is a plan view and Figures 5B and 5C are cross-sectional views of a sensor to detect a characteristic of the topography of a surface of a die. Figures 5A-5C are described with reference to "die", which may be "donor die", "target die", or both. A die may instead be a substrate (e.g., a collection of undiced die). The die may be a previously bonded die, such as a pair of die to which another die is to be bonded. The die are depicted as having similar dimensions, but may have different dimensions instead.

In Figure 5A, a set of die 504A-504F are supported by a structure 516. The characteristic of the topography of a surface of the die 504A-504F may be measured relative to the structure 516 or another plane, such as a plane of the sensor to detect a characteristic of the topography of the surface of the die (such as a plane of the sensor which supports the structure 516). The set of dies 504A-504F may be irradiated by a flat wavefront 570. The flat wavefront 570 may be of any appropriate wavelength, such as visible light, infrared, ultraviolet, etc. The flat wavefront 570 may have a wavelength which is much larger than the size of particles or differences in topography to be detected, such as 10 times larger or greater. The flat wavefront may be incident on the surface of the die 504A-504F at a substantially perpendicular angle (which will be depicted in more detail in Figure 5C), an oblique angle (depicted in more detail in Figure 5B), or any other appropriate angle. In some embodiments, the flat wavefront 570 may scan the surface of the set of dies 504A-504F in a first direction 571 (e.g., through relative movement between the wavefront 570 and the set of dies 504A-504F). The flat wavefront 570 may be redirected by (e.g., reflected off) the surface of the set of dies 504A-504F at an incident plane 572, where the flat wavefront 570 may be deformed by the topography of the surface of the one or more dies 504A-504F at the incident plane to generate a redirected (e.g., reflected) wavefront 574 which travels in a direction 575.

The wavefront 574 may contain information about the topography (e.g., flatness) of the surface for the one or more dies 504A-504F on which the wavefront 570 was incident. The wavefront 574 may be captured by a set of microlenses 580, which may be contained in a microlens array. The microlenses 580 of the microlens array may be evenly spaced, including contiguously. The microlenses 580 of the microlens array may be arrayed in any appropriate manner, including in one dimension, in two-dimensions, in a square grid, in a rectangular grid, in a close-packing arrangement, etc. In an embodiment, there may be 100 or more microlenses, 500 or more microlenses, 1000 or more microlenses, or 10,000 or more microlenses. In an embodiment, the array is two-dimensional and has 100 or more microlenses along one or both dimensions, 500 or more microlenses along one or both dimensions, or 1000 or more microlenses along one or both dimensions. The wavefront 574 may be magnified by or before the microlenses 580. The microlenses 580 may each focus a segment of the wavefront 574 on a focal plane 590. The microlenses 580 may have a theoretical focal point (e.g., theoretical focal point 592 corresponding to theoretical focus 582) which corresponds to a flat version of the reflected wavefront 574 (e.g., a wavefront 574 reflected by a substantially flat set of die 504A-504F). The microlenses 580 may have an actual focal point (e.g., actual focal point 594 corresponding to actual focus 584) which corresponds to the actual version of the wavefront 574. The flat version of the wavefront 574 need not be a perfectly flat wavefront, but may account for planned differences in die height (for example, between recessed areas of the die and non-recessed areas, between die and the carrier structure, etc.). The characteristic of the topography of a surface of the one or more dies 504A-504F may be determined based on a difference between the theoretical focal points 592 and the actual focal points 594 of the microlenses 580 (e.g., in a displacement of the actual focal points 594 from the theoretical focal points 592). In some embodiments, the location of the actual focal points 594 may be measured, such as by the position of radiation focused on a pixelated detector, which may be located at the focal plane 590. In some embodiments, the distance or displacement between the theoretical focal points 592 and the actual focal points 594 may be determined. In an embodiment, the difference between the theoretical focal points 592 and the actual focal points 594 may be captured by a radiation detector, such as a CCD. A screen (e.g., glass, plastic, etc.) which has blackout points corresponding to the theoretical focal points 592 may be interposed between the focal plane 590 and a radiation detector. The blackout points may block radiation of the actual focal points 594 from reaching the radiation detector for a die surface which is within a surface topography characteristic tolerance (e.g., threshold). If the topography of the surface (e.g., tilt and/or particle presence) is outside of that threshold, the actual focal point 594 may lie outside of the blackout point and cause the radiation detector to detect radiation and so indicate an undesired topography (e.g., one outside the threshold). Of course, a similar effect may be achieved using apertures instead of or in addition to blackout points, where, in the case of the apertures, the aperture would allow radiation meeting the threshold of the topography to pass while blocking the radiation when the radiation is outside the threshold of the topography such that non-detection by the detector of radiation would indicate an undesired topography (e.g., one outside the threshold). Each focal point may correspond to a die, region of a die, etc. In some embodiments, the characteristic of the topography of a surface of a die may be quantified at up to a nanometer in height per micron.

Figure 5B depicts a cross-sectional view of the flat wavefront 570, incident plane 572, and reflected wavefront 574 of Figure 5A on the die 504A-504C. In order to measure the characteristic of the topography of the surface of the die 504A-504C, the incident plane 572 may be swept across the die 504A-504C to cover substantially all of the surface. In some embodiments, the same or another sensor to detect a characteristic of the topography of the surface of a die may then sweep across the die (e.g., the die 504A-504C) in a substantially perpendicular direction in order to qualify the topography across the bonding surface. Of course, there may be multiple wavefronts 570 presented across a region having one or more dies to, e.g., decrease measuring time.

Figure 5C depicts an embodiment of the sensor in which the flat wavefront is a substantially two-dimensional wavefront, which is incident on the set of die 504A-504C substantially perpendicularly (e.g., in the direction 571 perpendicular to the bonding surface of the die 504A-504C). The redirected wavefront 574 is then likewise substantially two-dimensional (e.g., a plane wave) and travels to the microlenses 580 in the direction 575. The microlenses 580 may be arrayed in a two-dimensional array in order to capture the wavefront 574 substantially simultaneously. The microlenses 580 may focus segments (e.g., two-dimensional segments) of the wavefront 574 on a focal plane 590. The actual focal points 594 of the microlenses 580 (e.g., based on the wavefront 574) may be projected onto a detector screen 598. The detector screen may have, e.g., blackout points located at the theoretical focal points 592 which may operate to block out transmitted radiation for actual focal points 594 which correspond to theoretical focal points. In Figures 5A and 5C, the theoretical focal points 592 and blackout points are depicted as having the same size, but the blackout points may be larger than the theoretical focal points 592, such as to provide a tolerance to the topography qualification. In instances where the actual focal points 594 fall outside of the blackout points corresponding to the theoretical focal points 592, the detector screen 598 may light up (depicted as white circles on gray background in Figure 5C). Of course, the detector screen 598 may be implemented with apertures instead of in addition to the blackout points as described above. In addition or alternatively, a level system may be provided that is configured to measure a relative position between the plane of the microlenses 580 and the die 504A-504C to enable proper alignment of the die 504A-504C with the microlenses 580.

The presence or absence, as applicable, of radiation at a location may trigger a determination that a corresponding die (or region of a die) has failed a topography qualification and may be rejected for bonding. In some embodiments, multiple focal points may be measured for a given die. In some embodiments, a threshold number of focal points may need to be triggered for a die to be rejected for bonding. In some embodiments, if a threshold number of dies are indicated as non-flat or otherwise unsuitable for bonding, all the dies of the set may be rejected for bonding.

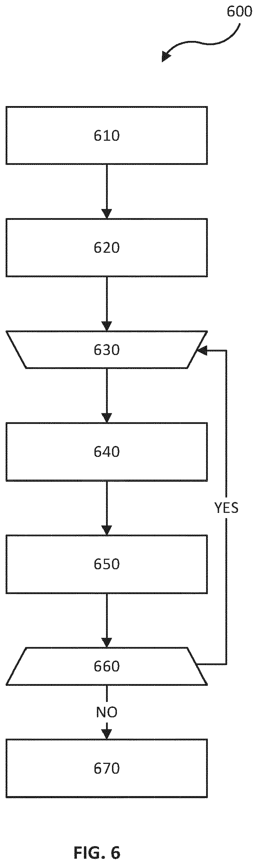

Figure 6 is a flowchart which illustrates an exemplary method of die placement. Each of these operations is described in detail below. The operations of method 600 presented below are intended to be illustrative. In some embodiments, method 600 may be accomplished with one or more additional operations not described, and/or without one or more of the operations discussed. Additionally, the order in which the operations of method 600 are illustrated in Figure 6 and described below is not intended to be limiting. In some embodiments, one or more portions of method 600 may be implemented (e.g., by simulation, modeling, etc.) in one or more processing devices (e.g., one or more processors). The one or more processing devices may include one or more devices executing some or all of the operations of method 600 in response to instructions stored electronically on an electronic storage medium. The one or more processing devices may include one or more devices configured through hardware, firmware, and/or software to be specifically designed for execution of one or more of the operations of method 600, for example.

At an operation 610, a plurality of donor die locations are obtained. The donor die locations may be obtained via measurement of one or more positions of the donor dies along one or more dimensions. The donor dies may lie on or be part of a donor substrate (e.g., a carrier structure, a semiconductor substrate, etc.), and the locations of the plurality of donor dies may be obtained with respect to that donor substrate. The locations of the plurality of donor die may be measured with respect to a measurement mark. The locations of the plurality of donor dies may be measured in-plane (e.g., in the x-y plane). The locations of the plurality of donor dies may also be measured via a first method in-plane and measured out of plane (e.g., in the Z direction) via a second method. For example, the locations of the plurality of donor dies may be measured based on one or more images in-plane. The locations of the plurality of donor dies may be obtained from a two-dimensional image, which may show locations of an edges or corner of a donor die with respect to positions on a support structure or on a die actuator. The locations of the plurality of donor dies may be obtained based on one or more features (for example, one or more electrically active areas) on an exposed surface of the donor die. These one or more features of the donor die may be used as an alignment mark or reference mark. In some embodiments, alignment marks may be included as exposed features of the donor die. The alignment marks may be specifically added for die bonding or may be alignment marks corresponding to previous fabrication steps. The plurality of donor die locations may be measured or obtained from storage.

At an operation 620, a plurality of target die locations are obtained. The target dies may lie on or be part of a target substrate (e.g., a carrier structure, a semiconductor substrate, etc.), and the locations of the plurality of target dies may be obtained with respect to that target substrate. The locations of the plurality of target die may be obtained in any appropriate method, including any of those described in reference to the operation 610.

At an operation 630, a donor die is selected from the plurality of donor dies. The donor die may be selected based on position (e.g., along a row, along a column), displacement (e.g., donor die closest to an ideal position), thickness (e.g., thicker dies may be placed before thinner dies, including if donor dies include two or more types of dies), etc. The donor die may have a corresponding target die, such as a target die in a corresponding location on a target substrate (e.g., target die carrier structure). In some embodiments, a target die may be selected, by any appropriate method, and a donor die selected based on its correspondence to the selected target die. The donor die and the target die may be brought together such that donor die and its corresponding target die are separated by a distance which may be traversed by the die placement method. The donor die and target die may be grossly aligned (e.g., coarse aligned), such as to within a threshold of coarse alignment. The donor die and target die may be held in proximity by one or more substrates, chucks, actuators, adhesives, etc.

At an operation 640, the relative position between the selected donor die and the corresponding target die is adjusted to have alignment between the donor die and the corresponding target die. Adjusted includes cases in which locations are minimally or substantially not adjusted (e.g., after measurement or bringing into proximity), such as if a measured location corresponds to the target location within a threshold. In an embodiment, the position of the donor die may be adjusted by action of a die actuator, a substrate holder, a chuck, etc. The position of the donor die may be adjusted by action of a substrate handling apparatus. The position of the donor die may be adjusted in one or more directions, such as in the X-Y plane. Alternatively or additionally to adjustment of the location of the donor die, the position of the target die may be adjusted, by any appropriate method, such as any of those previously described. Adjustment of the relative position between the donor and target die may include iterative measurement of donor and/or target die location, including as adjustment occurs.

Adjustment of the location of the donor die may occur based on an alignment location for the donor die. The alignment location may be a target (e.g., target location) for placement of the donor die. A target (e.g., target location) may be obtained, such as at operation 620, from measurement of the target die position. The target may correspond to a location of the target die. The target may correspond to a plurality of locations on the target die. The target may be a position (e.g., a position in three dimensions such as along X, Y, and Z axes, positions in six directions such as along X, Y, and Z axes and with respect to angles of rotation about those axes, etc.). The target may be a set of positions, for example two or more positions of or on a target die to which areas of the donor die are to be bonded. Additionally or alternatively, adjustment of the location of the target die may occur based on an alignment location for the target die. The alignment location may be a target (e.g., target location) for placement of the donor die. A target (e.g., target location) may be obtained, such as at operation 610, from measurement of the donor die position. The target may correspond to a location of the donor die. The target may correspond to a plurality of locations on the donor die.

At an operation 650, the selected donor die is placed on the corresponding target die. The donor die may be placed on the target die by any appropriate method, such as by movement of a die actuator, by radiation-mediated bonding, by stamping, by electrostatic attraction, etc. The donor die may experience alignment, including self-alignment, as the donor die is brought into contact with the target die. The donor die may be adhered to the target die as it contacts the target die, such as by van der Waals forces. In some embodiments, an additional donor die may be placed on the same or different target die.

At an operation 660, it is determined if additional donor die remain for placement. If additional donor die (e.g., on the donor substrate or substrate) remain for placement, the flow continues to the operation 630 where another donor die is selected. If no additional donor die remain for placement, flow continues to operation 670, where the bonding of the plurality of dies is completed.

In an embodiment, a particular donor die and target die are bonded at the time the donor die is placed on the target die, e.g., through intermolecular bonding. In an embodiment, the donor die is bonded, such as through annealing or other bonding process, to the target die after placement of the donor die on the target die. In an embodiment, a bonding of a donor and target die is completed before a next donor die is placed on a target die. In an embodiment, bonding of a donor and target die is completed after a plurality of donor dies are placed on respective target dies, e.g., after all the donor dies on a donor substrate are placed. In an embodiment, a donor die placed on a target die is annealed to form or enhance electrical connection. In an embodiment, the annealing of a particular donor die and target die can be done prior to a next donor die is placed on a target die. In an embodiment, annealing of a donor and target die is completed after a plurality of donor dies are placed on respective target dies, e.g., after all the donor dies on a donor substrate are placed. The donor die may be held against the target die for a bonding or annealing time period. A donor die and target die pair may be released from a substrate or other holding apparatus before annealing or after annealing has occurred.

As described above, method 600 (and/or the other methods and systems described herein) is configured for die placement.

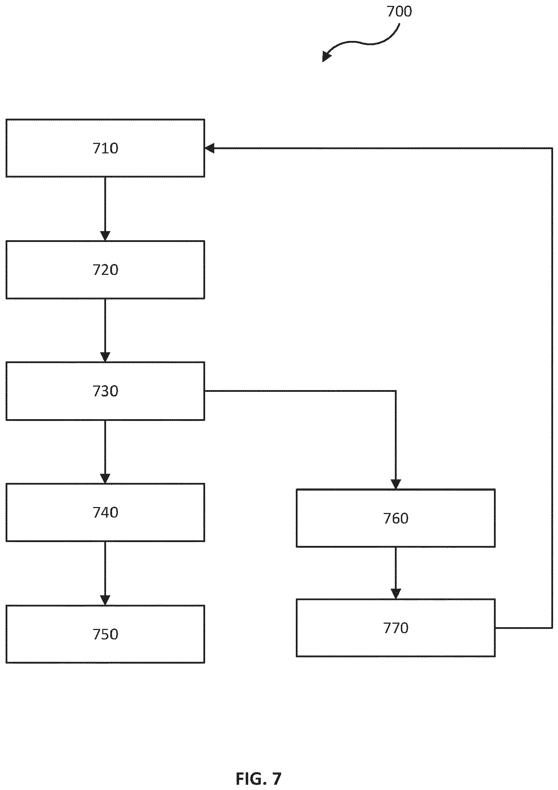

Figure 7 is a flowchart which illustrates an exemplary method 700 for topography qualification. Each of these operations is described in detail below. The operations of method 700 presented below are intended to be illustrative. In some embodiments, method 700 may be accomplished with one or more additional operations not described, and/or without one or more of the operations discussed. Additionally, the order in which the operations of method 700 are illustrated in Figure 7 and described below is not intended to be limiting. In some embodiments, one or more portions of method 700 may be implemented (e.g., by simulation, modeling, etc.) by or in one or more processing devices (e.g., one or more processors). The one or more processing devices may include one or more devices causing execution of some or all of the operations of method 700 in response to instructions stored electronically on an electronic storage medium. The one or more processing devices may include one or more devices configured through hardware, firmware, and/or software to be specifically designed for execution of one or more of the operations of method 700, for example.

At an operation 710, a die is illuminated with radiation having a substantially flat wavefront in at least one dimension. The substantially flat wavefront may be a one-dimensional wavefront. The substantially flat wavefront may be a two-dimensional (e.g., planar) wavefront. A substantially flat wavefront may have minimal distortions on the order of the size of the die, features of the die, wavelength of the radiation, etc. The die may be illuminated substantially perpendicular to a bonding surface. The die may be illuminated obliquely with respect to the bonding surface. The die may be supported by a carrier or any other appropriate support structure. The die may be a partially diced or undiced die, such as a die integrated into a wafer. The die may have one or more recessed areas. The die may have been subject to a cleaning and/or planarization process, such as to provide a relatively smooth surface suitable for bonding. The die may be any die suitable for die bonding, such as a donor die, an acceptor die, or a combination thereof.

At an operation 720, the radiation is redirected (e.g., reflected) by the surface of the die. The radiation may have any appropriate wavelength such that it is substantially redirected by the surface of the die. The radiation may be redirected at any appropriate angle. The redirection of the substantially flat wavefront by the surface of the die may deform the wavefront, to produce a redirected wavefront which may no longer be substantially flat. The wavefront may be deformed by absorption, reflection, reflection at different depths, diffraction, etc. The shape of the redirected wavefront may reflect a topography, such as shape, smoothness (e.g., roughness), etc., of the bonding surface of the die.

At an operation 730, a characteristic of the topography of the surface of the die may be qualified based on the redirected radiation. The topography qualification may include a tilt qualification. The topography qualification may include a particle presence and/or absence qualification. The topography qualification may be based on a comparison of the redirected radiation from the die to a theoretical redirected radiation from a planned die. The topography qualification may be based on passing of the redirected radiation through a microlens array and measurement in relation to the positions of the focal points. The topography qualification may be based on any appropriate method, such as those described in relation to Figures 5A-5C. Multiple dies may be processed simultaneously by operations 710-730.

At an operation 740, based on the topography qualification, one or more dies may be selected for die bonding. One or more dies which have a topography qualification , e.g., within a threshold may be selected for die bonding. The threshold may correspond to a minimum flatness (such as less than or equal to 1 nm per micron). The threshold may correspond to a minimum number of particles per area. The threshold may correspond to a detection limit, where any detectable surface topography may trigger rejection of the die for die bonding. One or more dies may be selected by any appropriate method, such as by an alignment mechanism, a processor (such as for inclusion in a die bonding process), etc.

At an operation 750, the one or more dies selected for die bonding may be bonded to a target and/or donor die. The one or more dies may be bonded by any appropriate method, such as light mediated release, hybrid bonding, etc.

At an operation 760, based on the topography qualification, one or more dies may be rejected for die bonding. One or more dies which have a topography qualification, e.g., outside of a threshold (such as have a tilt, roughness, or particle count which exceeds a threshold) may be rejected for die bonding. Rejection for die bonding may include cleaning or planarization of the die. Rejection for die bonding may indicate that a die is to be discarded. Rejection for die bonding may indicate that a die is to be removed from a carrier before another die on the carrier is bonded. Rejection for die bonding may indicate that a die is to be left on a carrier but skipped during alignment and bonding steps in a die bonding process. How the die is treated may depend on the measure of die topography. For example, a die which is highly tilted (such as to a height greater than 50% of a neighbor) may be removed from the carrier in order to not interfere with bonding of another die. A die which has a high particle count may trigger re-cleaning of an entire carrier containing multiple dies, as the high particle count may indicate that the cleaning process was incomplete. In another example, a die with a single large particle may be skipped during bonding and sent for re-cleaning after one or more other dies on the carrier are bonded.

At an operation 770, the one or more dies rejected for die bonding may be re-processed for die bonding. The one or more rejected dies may be re-positioned, re-cleaned, or otherwise reprocessed. Once reprocessed, the rejected one or more dies may again be subject to operation 710. In some embodiments, a die may be re-processed a finite number of times, and once a die has reached a re-processing threshold it may be discarded. In some embodiments, the re-processing threshold may be one, and a die which is rejected may be discarded instead of reprocessed.

As described above, method 700 (and/or the other methods and systems described herein) is configured for die topography (e.g., flatness) qualification.

In an embodiment, the techniques and apparatus herein can be applied to die to die bonding, substrate to substrate bonding, die to substrate bonding, etc. For example, the techniques and apparatus herein can be applied to bonding an individual donor die to an individual target die. In an embodiment, the techniques and apparatus herein can be applied to bonding a group of donor dies to one or more target dies at a substantially same time or a group of target dies to one or more donor dies at a substantially same time. In an embodiment, the techniques and apparatus herein can be applied to bonding one or more donor dies to a substrate comprising one or more target dies formed therein or thereon or bonding one or more target dies to a substrate comprising one or more donor dies formed therein or thereon. In an embodiment, the techniques and apparatus herein can be applied to bonding a full or partial substrate comprising donor dies to one or more target dies or bonding a full or partial substrate comprising target dies to one or more donor dies. Thus, the techniques and apparatus herein can be applied to practically every form of die bonding, whether bonding dies individually, bonding dies in a group, bonding dies as part of a full or partial substrate, etc.

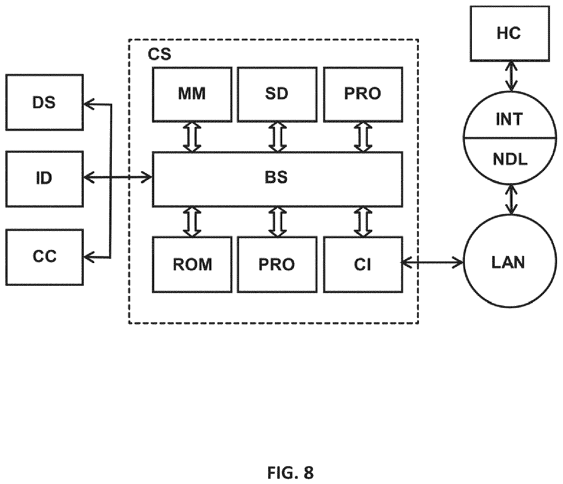

Figure 8 is a diagram of an example computer system CS that may be used to implement one or more of the operations described herein. Computer system CS includes a bus BS or other communication mechanism for communicating information, and a processor PRO (or multiple processors) coupled with bus BS for processing information. Computer system CS also includes a main memory MM, such as a random-access memory (RAM) or other dynamic storage device, coupled to bus BS for storing information and instructions to be executed by processor PRO. Main memory MM also may be used for storing temporary variables or other intermediate information during execution of instructions by processor PRO. Computer system CS further includes a read only memory (ROM) ROM or other static storage device coupled to bus BS for storing static information and instructions for processor PRO. A storage device SD, such as a magnetic disk or optical disk, is provided and coupled to bus BS for storing information and instructions.

Computer system CS may be coupled via bus BS to a display DS, such as a cathode ray tube (CRT) or flat panel or touch panel display for displaying information to a computer user. An input device ID, including alphanumeric and other keys, is coupled to bus BS for communicating information and command selections to processor PRO. Another type of user input device is cursor control CC, such as a mouse, a trackball, or cursor direction keys for communicating direction information and command selections to processor PRO and for controlling cursor movement on display DS. This input device typically has two degrees of freedom in two axes, a first axis (e.g., x) and a second axis (e.g., y), that allows the device to specify positions in a plane. A touch panel (screen) display may also be used as an input device.

In some embodiments, portions of one or more methods described herein may be performed by computer system CS in response to processor PRO executing one or more sequences of one or more instructions contained in main memory MM. Such instructions may be read into main memory MM from another computer-readable medium, such as storage device SD. Execution of the sequences of instructions included in main memory MM causes processor PRO to perform one or more process steps (operations) described herein. One or more processors in a multi-processing arrangement may also be employed to execute the sequences of instructions contained in main memory MM. In some embodiments, hard-wired circuitry may be used in place of or in combination with software instructions. Thus, the description herein is not limited to any specific combination of hardware circuitry and software.

The term "computer-readable medium" and/or "machine readable medium" as used herein refers to any medium that participates in providing instructions to processor PRO for execution. Such a medium may take many forms, including but not limited to, non-volatile media, volatile media, and transmission media. Non-volatile media include, for example, optical or magnetic disks, such as storage device SD. Volatile media include dynamic memory, such as main memory MM. Transmission media include coaxial cables, copper wire and fiber optics, including the wires that comprise bus BS. Transmission media can also take the form of acoustic or radiation waves, such as those generated during radio frequency (RF) and infrared (IR) data communications. Computer-readable media can be non-transitory, for example, a floppy disk, a flexible disk, hard disk, magnetic tape, any other magnetic medium, a CD-ROM, DVD, any other optical medium, punch cards, paper tape, any other physical medium with patterns of holes, a RAM, a PROM, and EPROM, a FLASH-EPROM, any other memory chip or cartridge. Non-transitory computer readable media can have instructions recorded thereon. The instructions, when executed by a computer, can implement any of the operations described herein. Transitory computer-readable media can include a carrier wave or other propagating electromagnetic signal, for example.

Various forms of computer readable media may be involved in carrying one or more sequences of one or more instructions to processor PRO for execution. For example, the instructions may initially be borne on a magnetic disk of a remote computer. The remote computer can load the instructions into its dynamic memory and send the instructions over a telephone line using a modem. A modem local to computer system CS can receive the data on the telephone line and use an infrared transmitter to convert the data to an infrared signal. An infrared detector coupled to bus BS can receive the data carried in the infrared signal and place the data on bus BS. Bus BS carries the data to main memory MM, from which processor PRO retrieves and executes the instructions. The instructions received by main memory MM may optionally be stored on storage device SD either before or after execution by processor PRO.

Computer system CS may also include a communication interface CI coupled to bus BS. Communication interface CI provides a two-way data communication coupling to a network link NDL that is connected to a local network LAN. For example, communication interface CI may be an integrated services digital network (ISDN) card or a modem to provide a data communication connection to a corresponding type of telephone line. As another example, communication interface CI may be a local area network (LAN) card to provide a data communication connection to a compatible LAN. Wireless links may also be implemented. In any such implementation, communication interface CI sends and receives electrical, electromagnetic, or optical signals that carry digital data streams representing various types of information.

Network link NDL typically provides data communication through one or more networks to other data devices. For example, network link NDL may provide a connection through local network LAN to a host computer HC. This can include data communication services provided through the worldwide packet data communication network, now commonly referred to as the "Internet" INT. Local network LAN (Internet) may use electrical, electromagnetic, or optical signals that carry digital data streams. The signals through the various networks and the signals on network data link NDL and through communication interface CI, which carry the digital data to and from computer system CS, are exemplary forms of carrier waves transporting the information.

Computer system CS can send messages and receive data, including program code, through the network(s), network data link NDL, and communication interface CI. In the Internet example, host computer HC might transmit a requested code for an application program through Internet INT, network data link NDL, local network LAN, and communication interface CI. One such downloaded application may provide all or part of a method described herein, for example. The received code may be executed by processor PRO as it is received, and/or stored in storage device SD, or other non-volatile storage for later execution. In this manner, computer system CS may obtain application code in the form of a carrier wave.

Embodiments include the following numbered clauses:
Clause 1: A sensor configured to determine a characteristic of a topography of a surface of one or more semiconductor dies, the sensor comprising:
   a radiation emission system configured to emit radiation having a substantially flat wavefront; and
   a radiation detector configured to detect at least some of the radiation after reflection by the one or more semiconductor dies to determine the characteristic of one or more semiconductor dies.
Clause 2: The sensor of clause 1, wherein the radiation detector is further configured to detect a flatness and/or tilt of reflected wavefront in the at least some radiation.
Clause 3: The sensor of clause 2, wherein the flatness and/or tilt of the reflected wavefront corresponds to a flatness of the one or more semiconductor dies.
Clause 4: The sensor of any preceding clause, further configured to detect, based on the determined characteristic of one or more semiconductor dies, a presence and/or absence of particles on a surface of the one or more semiconductor dies.
Clause 5: The sensor of clause 4, configured to detect the presence of particles on a bonding surface of the one or more semiconductor dies.
Clause 6: The sensor of any preceding clause, configured to determine the characteristic for multiple semiconductor dies substantially simultaneously, and wherein the radiation detector is configured to detect the at least some radiation after reflection by the multiple semiconductor dies substantially simultaneously.
Clause 7: The sensor of any preceding clause, wherein the radiation detector further comprises an array of microlenses, the array of microlenses configured to focus portions of the at least some radiation on the radiation detector.
Clause 8: The sensor of clause 7, further configured to determine the characteristic of the topography of the surface of one or more semiconductor dies based on positions of the focused portions of the at least some radiation on corresponding regions of the radiation detector.
Clause 9: The sensor of clause 7 or clause 8, wherein the radiation detector further comprises a camera and a set of target focus locations, the set of target focus locations corresponding to target focal points for the one or more semiconductor dies in a flat and/or particle free state, and wherein the flatness sensor is configured to determine the flatness for the one or more semiconductor dies based on a difference between the set of target locations and focused portions of the at least some radiation transmitted through the array of microlenses.
Clause 10: The sensor of clause 7 or clause 8, further comprising a structure to block at least some of the at least some radiation prior to the detector and the flatness sensor is configured to determine the characteristic of the topography of the surface of the one or more semiconductor dies based on the detection by the detector of unblocked radiation or based on the non-detection by the detector of radiation.
Clause 11: The sensor of clause 10, wherein at least one dimension and/or shape of the structure to block at least some of the radiation is configured to provide a threshold and/or tolerance in the detection of unblocked radiation or the non-detection of the radiation.
Clause 12: The sensor of any preceding clause, wherein the substantially flat wavefront is emitted and/or the at least some radiation is reflected substantially perpendicular to an external surface of the one or more semiconductor dies.
Clause 13: The sensor of any of clauses 1 to 10, wherein the substantially flat wavefront is emitted at least partially parallel to one of the two axes of an external surface of the one or more semiconductor dies.
Clause 14: The sensor of any preceding clause, wherein the one or more semiconductor dies are integrated in a wafer.
Clause 15: The sensor of any of clauses 1 to 13, wherein the one or more semiconductor dies are diced dies.
Clause 16: The sensor of clause 15, wherein the diced dies applied to a carrier substrate.
Clause 17: The sensor of any preceding clause, configured to generate at least 1000 measurement points of the characteristic of the topography of the surface of the one or more semiconductor dies.
Clause 18: A sensor configured to determine a presence and/or absence of contamination on one or more semiconductor dies, the sensor comprising:
   a radiation emission system configured to emit radiation having a substantially flat wavefront; and
   a radiation detector configured to detect at least some of the radiation after reflection by the one or more semiconductor dies to determine the presence and/or absence of contamination on one or more semiconductor dies.
Clause 19: A system comprising:
   the sensor of any of clauses 1 to 18; and
   a movable substrate configured to provide relative movement between the emitted radiation and the one or more semiconductor dies.
Clause 20: The system of clause 19, further comprising a die bonding system configured to bond a die to the one or more semiconductor dies.
Clause 21: The system of clause 19 or clause 20, further comprising an alignment system configured to measure a position of the one or more semiconductor dies.
Clause 22: The system of any of clauses 19 to 21, further comprising a level system configured to measure a height and/or orientation of the one or more semiconductor dies.
Clause 23: A system for die bonding comprising a sensor configured to determine a flatness of and/or presence of particles on, a surface of a die prior to bonding.
Clause 24: The system of clause 23, wherein the sensor comprises the sensor of any of clauses 1 to 15. Clause 25: The system of clause 23 or clause 24, further configured to accept and/or reject a semiconductor die for die bonding based on output of the sensor.
Clause 26: The system of any of clauses 23 to 25, further configured to, based on the output of the sensor, reposition a semiconductor die and/or output the die for cleaning prior to bonding.
Clause 27: A particle detector, wherein the particle detector comprises the sensor of any of clause 1 to 18.
Clause 28: A method comprising:
   illuminating one or more semiconductor dies with radiation comprising a substantially flat wavefront;
   detecting, by a radiation detector, at least some of the radiation reflected from the one or more semiconductor dies; and
   determining, based on the detected reflected radiation, a characteristic of the topography of a surface of the one or more semiconductor dies.
Clause 29: The method of clause 28, wherein detecting the at least some radiation further comprises focusing the at least some radiation on the radiation detector by an array of microlenses.
Clause 30: The method of clause 29, wherein determining the characteristic of the topography of the surface of the one or more semiconductor dies comprises determining the characteristic based on a difference between positions of focused portions of the at least some radiation transmitted through the array of microlenses and target focal points, the target focal points corresponding to focal points for a flat and/or substantially particle free semiconductor die.
Clause 31: The method of any of clauses 28 to 30, wherein determining the characteristic of the topography of the surface of the one or more semiconductor die comprises determining a presence and/or absence of particles on one or more surfaces of the one or more semiconductor dies.
Clause 32: The method of any of clauses 28 to 31, further comprising bonding the one or more semiconductor dies to a target location based on the determined characteristic.
Clause 33: The method of any of clauses 28 to 32, further comprising rejecting, based on the determined characteristic, for bonding one or more non-flat semiconductor dies and/or one or more semiconductor dies with one or more particles thereon.
Clause 34: The method of clause 33, wherein the rejected one or more semiconductor dies are repositioned and/or cleaned before bonding to one or more target locations.
Clause 35: A semiconductor die bonded to a further semiconductor die and/or wafer produced the method of any clauses 28 to 34.
Clause 36: One or more non-transitory, machine-readable medium having instructions therein, the instructions, when executed by a processor system, configured to cause the processor system to operate at least the sensor of any of clauses 1 to 18, the system of any of clauses 19 to 26, and/or the particle detector of clause 27.
Clause 37: One or more non-transitory, machine-readable medium having instructions therein, the instructions, when executed by a processor system, configured to cause the processor system to perform at least the method of any of clauses 28 to 34.

While the concepts disclosed herein may be used for manufacturing with a substrate such as a silicon wafer, it shall be understood that the disclosed concepts may be used with any type of manufacturing system (e.g., those used for manufacturing on substrates other than silicon wafers).

In addition, the combination and sub-combinations of disclosed elements may comprise separate embodiments. For example, one or more of the operations described above may be included in separate embodiments, or they may be included together in the same embodiment.

The descriptions above are intended to be illustrative, not limiting. Thus, it will be apparent to one skilled in the art that modifications may be made as described without departing from the scope of the claims set out below.

## Claims

1. A sensor configured to determine a characteristic of a topography of a surface of one or more semiconductor dies, the sensor comprising:
a radiation emission system configured to emit radiation having a substantially flat wavefront; and
a radiation detector configured to detect at least some of the radiation after reflection by the one or more semiconductor dies to determine the characteristic of one or more semiconductor dies.

2. The sensor of claim 1, wherein the radiation detector is further configured to detect a flatness and/or tilt of reflected wavefront in the at least some radiation.

3. The sensor of claim 2, wherein the flatness and/or tilt of the reflected wavefront corresponds to a flatness of the one or more semiconductor dies.

4. The sensor of claim 1, further configured to detect, based on the determined characteristic of one or more semiconductor dies, a presence and/or absence of particles on a surface of the one or more semiconductor dies.

5. The sensor of claim 4, configured to detect the presence of particles on a bonding surface of the one or more semiconductor dies.

6. The sensor of claim 1, configured to determine the characteristic for multiple semiconductor dies substantially simultaneously, and wherein the radiation detector is configured to detect the at least some radiation after reflection by the multiple semiconductor dies substantially simultaneously.

7. The sensor of claim 1, wherein the radiation detector further comprises an array of microlenses, the array of microlenses configured to focus portions of the at least some radiation on the radiation detector.

8. The sensor of claim 7, further configured to determine the characteristic of the topography of the surface of one or more semiconductor dies based on positions of the focused portions of the at least some radiation on corresponding regions of the radiation detector.

9. The sensor of claim 7, wherein the radiation detector further comprises a camera and a set of target focus locations, the set of target focus locations corresponding to target focal points for the one or more semiconductor dies in a flat and/or particle free state, and wherein the flatness sensor is configured to determine the flatness for the one or more semiconductor dies based on a difference between the set of target locations and focused portions of the at least some radiation transmitted through the array of microlenses.

10. The sensor of claim 7, further comprising a structure to block at least some of the at least some radiation prior to the detector and the flatness sensor is configured to determine the characteristic of the topography of the surface of the one or more semiconductor dies based on the detection by the detector of unblocked radiation or based on the non-detection by the detector of radiation.

11. The sensor of claim 10, wherein at least one dimension and/or shape of the structure to block at least some of the radiation is configured to provide a threshold and/or tolerance in the detection of unblocked radiation or the non-detection of the radiation.

12. The sensor of claim 1, wherein the substantially flat wavefront is emitted at least partially parallel to one of the two axes of an external surface of the one or more semiconductor dies.

13. The sensor of claim 1, wherein the one or more semiconductor dies are integrated in a wafer, or wherein the one or more semiconductor dies are diced dies.

14. A system for die bonding comprising the sensor of claim 1 configured to determine a flatness of and/or presence of particles on, a surface of a die prior to bonding.

15. A method comprising:
illuminating one or more semiconductor dies with radiation comprising a substantially flat wavefront;
detecting, by a radiation detector, at least some of the radiation reflected from the one or more semiconductor dies; and
determining, based on the detected reflected radiation, a characteristic of the topography of a surface of the one or more semiconductor dies.
